(19) Europäisches Patentamt
European Patent Office
Office européen des brevets

(11) EP 2 290 123 A1

(12) EUROPEAN PATENT APPLICATION

(43) Date of publication:
02.03.2011 Bulletin 2011/09

(21) Application number: 09169114.7

(22) Date of filing: 01.09.2009

(51) Int Cl.:
C23C 16/30 (2006.01) C23C 16/34 (2006.01)
C23C 16/56 (2006.01) C30B 33/00 (2006.01)
C30B 33/12 (2006.01) C30B 25/02 (2006.01)
C30B 25/18 (2006.01)

(84) Designated Contracting States:
AT BE BG CH CY CZ DE DK EE ES FI FR GB GR HR HU IE IS IT LI LT LU LV MC MK MT NL NO PL PT RO SE SI SK SM TR

(71) Applicant: Universität des Saarlandes Wissens- und Technologietransfer GmbH
66123 Saarbrücken (DE)

(72) Inventors:
- Dr. rer. nat. Sachdev, Hermann
66123, Saarbrücken (DE)
- Dr. rer. nat. Müller, Frank
66125, Saarbrücken (DE)
- Prof.Dr.Dr.h.c.mult. Hüfner, Stefan
66121, Saarbrücken (DE)

(74) Representative: Neidlein, Helga et al
Gille Hrabal Struck Neidlein Prop Roos
Patent Attorneys
Bruckne rstrasse 20
40593 Düsseldorf (DE)

(54) **Processes for producing thin metal nitride layers, inter alia making use of a selective decomposition of alcoholates, processes for hardening a surface, for obtaining thin oxygen compound layers, articles comprising said layers and uses thereof, and a process for obtaining metal hydrides and aldehydes/ketones**

(57) Disclosed are two processes for obtaining thin metal nitride layers on a substrate, a process for hardening such surface by implanting metal atoms, a process for obtaining thin oxygen compound layers on such hardened surface and several uses of the obtained articles as well as the articles comprising the obtained layers. Further, a process for obtaining metal hydrides and carbonyl compounds from metal alcoholates on a substrate are disclosed.

EP 2 290 123 A1

## Description

## Introduction

The present invention relates to processes for producing thin layers of metal nitride, preferably boronitrene, to articles comprising said layers, a use of such layer in the manufacture of electronic devices, a process of hardening a surface of a substrate, a process for forming a thin oxygen compound layer on a surface, articles comprising said hardened surface or oxygen compound layer, uses of said articles, a use of an epitaxial Rh(111) surface substrate in a process as defined before, an article comprising said substrate and a thin nitride layer, hardened surface or thin oxygen compound layer, and a process for obtaining metallohydrides and aldehydes/ketones.

## Prior art

Boron nitride has been known for many years. It exists in several crystal modifications, the cubic boron nitride (CBN) and hexagonal boron nitride (h-BN) being the most widespread known ones. CBN is widely used as an abrasive or material for cutting tool inserts, which is frequently provided in multilayer elements. Its hardness is the second-highest known, and due to its temperature stability it is even preferred to diamonds in many grinding applications. CBN can be formed of h-BN under high pressure of more than 6000 MPa and high temperatures above 1500 ˚C.

h-BN has a graphite-like crystal structure. It is described e.g. in M. Engler et al., cfi/Ber. DKG 84 (2007) 12, E49-E53. Due to its graphite-like structure, h-BN has many interesting properties, such as high thermal conductivity, electric insulation capacity, low specific density, good processability, compatibility with many materials, low friction, low wettability. It is, e.g., used as a lubricant, for shaped parts such as sealing elements in oxygen sensors, evaporation boats for aluminum, composite material to be used in the steel and non-ferrous metal industry, as powders and granulates as functional additives used for the thermal management of computers, automotive electronics, climatronics, medical engineering, lighting and many other sectors.

Conventionally, boron nitride powder is manufactured in an industrial scale in a two-step process. In the first step at around 900 ˚C a boron source, such as $B_2O_3$ (boron oxide) or $H_3BO_3$ (boric acid) is converted in a reaction with a nitrogen source (mostly melamine or urea, sometimes $NH_3$) to amorphous boron nitride. In the second step, this crystallizes at temperatures usually above 1600 ˚C in an $N_2$ atmosphere. First a transition into the turbostratic, then into the mesographitic and finally into the hexagonal phase of h-BN is observed.

With increasing miniaturization in technology the engineering of future generations of electronic devices by applying standard techniques becomes more and more difficult, and especially after crossing the border to nanotechnology, the manufacturing of a particular design by "external" methods will reach its limits. Of course, a "message" can be written by aligning a few atoms with the tip of an STM (scanning tunneling microscope), but this way to manipulate surface structures is only appropriate for applications on a local scale rather than for mass production of large-scale nano devices.

Another way for the engineering of large scale nanostructures with a high degree of order is to use the phenomenon of self-assembly. This mechanism occurs during the epitaxial growth of thin films on substrates of different lattice parameters and/or different point symmetries. Depending on the lattice mismatch, periodicities in the range of a few Angstroms (as for a usual crystal) can be extended to the range of a few nanometers, as given by the coincidence lattice of the film and the substrate. Additionally, the enlarged unit cells of such superstructures can exhibit complex topographies (R. Laskowski et al., Phys. Rev. Lett. 98, 106802 (2007), R. Laskowski et al., J. Phys. Condens. Matter 20, 064207 (2008), M. Corso et al., Science 303, 217 (2004), S: Berner et al., Angewandte Chemie 46, 5115 (2007)) that can be used as templates for the alignment of molecules (H. Dil et al., Science 319, 1826 (2008), a useful property, especially for the engineering of electronic devices in the post silicon era.

With respect to the latter aspect, the epitaxial growth of boron nitride (BN) on transition metal surfaces is of particular interest because it offers the possibility to get an insulator of exactly one monolayer.

A recent example of BN layers represents the formation of a superstructured mono-layer of boron nitride on a transition metal substrate. The formation of a highly regular self-assembled BN nanostructure with a periodicity of 3.22 nm on Rh(111) by CVD (Chemical Vapor Deposition) of borazine was first obtained by Corso et al. (M. Corso et al., Science, 303 (2004), 217) and the BN monolayer structure was modelled by Laskowski et al. (R. Laskowski et al., Phys. Rev. Lett. 98 (2007) 106802). Such BN layers represent a two-dimensional quantum barrier with a polar surface.

Subsequently, the ability of this periodic nanostructure to act as a template was demonstrated (S. Berner et al., Angew. Chemie 46 (2007) 5115). The variation of the lattice mismatch between the BN lattice and the lattice of the substrate crystal offers the possibility to tune the size of nanostructures for applications in technology, e.g. in nanoelectronic devices (Editorial note in Nature Nanotechnology 2 (2007) 459). In the current literature there are several reports regarding the syntheses of BN monolayers on transition metal substrates based on borazine (see below), but there is little information regarding the stability and chemical reactivity of such BN monolayers (S. Berner et al., supra,

and A. Goriachko et al., J. Phys. Chem. C 112 (2008) 10432-10427). Nucleation and growth reactions of boronitride on transition metal surfaces from borazine as a molecular precursor are of general interest to understand the h-BN crystal growth as a solid with high structural anisotropy. These aspects are also important regarding the syntheses of boron nitride modifications by various means of deposition techniques based on CVD- and PVD- (physical vapor deposition) methods (H. Sachdev et al,, Diamond and Related Materials 8 (1999) 319, B. Lux et al., Super Carbon (1998) 127, X. W: Zhang et al, Nature Materials 2 (2003), 1539, J. Yu et al., Diamond Related Materials 12 (2003) 1539, P.B. Mirkarimi et al., J. Mater. Res. 9 (1994) 2925), highpressure-high-temperature synthesis (R.C: de Vries et al., J. Cryst. Growth 13-14 (1972) 88, O. Mishima et al., Science 238 (1987) 181, O. Fukunaga et al., Diamond Relat. Mater. 13 (2004) 1709, T. Taniguchi et al., Jpn. J. Appl. Phys. 41 (2002) L109-L111), or synthesis at ambient pressure (Y. Kubota et al., Science 317 (2007) 932-934), and there is a continuous interest in these materials due to their electronic properties.

In recent years there have been numerous reports regarding a concept of CVD, where a volatile molecular precursor contains structural motifs also present in the solid to be built up. The concept of CVD is based on the fact that a molecular precursor enables a facile formation of a solid material mainly with a structural motif, represented in parts by the molecular precursor (cf. hexagonal $B_3N_3$ ring in benzene-like borazine, $B_3N_3H_6$, vs $B_3N_3$ honeycomb in boronitrene). For applications, it is of general interest to achieve $sp^2$-type coordinated boron nitride monolayers in high quality and even with an undulated superstructure which can act as a template. Therefore, a detailed understanding not only of the reactions at the substrate-film interface, surface and rim of the formed solid (i.e. reactions during film formation) is necessary, but also knowledge of the phase stability and chemical reactivity is mandatory in order to tune the growth and properties of the resulting films (H. Sachdev et al., Diamond and Related Materials 8 (1999) 319, H. Sachdev et al., Diamond and Related Materials 9 (2000) 614-619, H. Sachdev , Diamond and Related Materials 10 (2000) 1390-1397). The mechanistic details regarding the formation of well-ordered BN monolayers in general are still unknown and a major question is whether substrate effects or precursor issues are mainly responsible for the buildup. Investigations dealing with growth aspects and the chemical reactivity of the deposited phases are of general interest to understand the mechanisms leading to the film formation (H. Sachdev et al., supra).

In the literature, the term h-BN is frequently used in connection with thin boron nitride layers.

The preparation of h-BN monolayers benefits from the fact that the growth rate for BN strongly drops after the formation of the first layer, as shown by Nagashima et al.

(Nagashima et al., Surf. Sci. 357-358, 307 (1996)) for the growth of h-BN on an isostructural Ni(111) surface. Especially after the discovery of a self-assembled superstructure of h-BN on a Rh(111) surface by Corso et al. (supra), the so-called h-BN "NanoMesh", the growth of h-BN gained new interest and investigations were extended to a large variety of metal surfaces such as Ag, Cr, Pt, Rh, Pd, Ni, Ru, Mo under various aspects (F. Müller et al., Surf. Sci. 520, 158 (2002), F. Müller et al., Surf. Sci. 602, 3467 (2008), F. Müller et al., Chem. Mater. 17, 3464 (2005), A.B. Preobrajenski et al., Phys. Rev. B75, 245412 (2007), M. Morscher et al., Surf. Sci. 600, 3280 (2006), W. Auwärter at al., Surf. Sci. 429, 229 (1999), W. Auwärter et al., Chem. Mater. 16, 343 (2004), W. Auwärter et al., Surf. Sci. 545, L735 (2003), J. Osterwalder et al., e-J. Surf. Sci. Nanotech. 1, 124 (2003), M. Muntwiler et al., Phys. Rev. B75, 075407 (2007), T. Greber et al., Proceedings ALC05, e-J. Surf. Sci. Nanotech. 4, 410 (2006), M.T. Paffett et al., Surf. Sci. 232, 286 (1990), M. Corso et al., Surf. Sci. 577, L78 (2005), A. Goriachko et al., Langmuir (Letters) 23, 2928 (2007), M.P. Allan, Nanoscale Res. Lett. 2, 94 (2007)).

Up to now, the preparation of the h-BN follows the same recipe: boron and nitrogen are provided via CVD of a liquid precursor, namely benzene-like borazine $(HBNH)_3$ or its isostructural counterpart trichloroborazine $(HBNCl)_3$. From the preparative point of view, both precursors are easy to handle, at least on the laboratory scale: since the growth of boronitrene is self-restricted by the drop of the growth rate (Nagashima, supra), the preparation of a well-ordered h-BN monolayer just requires opening an inlet valve for a short period.

However, both precursors are not without problems, especially with respect to synthesis (large amount of $H_2$ (O.R. Lourie et al., Chem. Mater. 12, 1808 (2000), hazardous properties (K.T. Moon et al., Journal of Ind. And. Eng. Chemistry 3, 288 (1997) and economic costs (for example, depending on puritiy the costs for 1000 ml borazine can be extrapolated to about 10000 - 20000 $).

Since these aspects are important for a large scale production of boron nitride layers, there was a demand for a method of preparing well-ordered boron nitride by using low-cost standard chemicals.

Thus one object of the invention was to provide a new, economic process for manufacturing highly-ordered metal nitride layers, in particular boron nitride layers. Further, the object of the invention was to provide new uses of such layers and intermediate layers occurring during their production. Further objects will become apparent form the following description.

## Disclosure of the invention

The present invention provides, in a first aspect, a process for forming thin layers of metal nitrides on a surface as defined in claims 1 to 6.

Claim 1 defines a process for forming thin layers of metal nitrides MN, wherein M is an element selected from the group consisting of B, Al, Si, Ge, Sn Ti, Zr, Hf, the lanthanides, the actinides and the transition metals, on a surface, comprising the steps

(a) providing a thin nitride layer by a conventional CVD or PVD method on a substrate,
(b) oxidation of the nitride layer using oxygen gas,
(c) nitrification of the oxidized layer using a nitrogen-containing gas,
(d) optionally annealing by heating.

Regarding the current terminology used in literature, it has to be noted that boron nitride monolayers, e.g. those obtained from CVD of borazines, are generally referred to as hexagonal boron nitride (h-BN) monolayers. This term is to some extent misleading because of the following reasons:

- These monolayers do not necessarily represent a structural unit of a hexagonal boron nitride crystal, since they can be bulged, undulated or corrugated, and even a monolayer of an other boron nitride modification, e.g. rhombohedral BN (*r*-BN), has the same connectivity as a monolayer of hexagonal boron nitride (cf. Fig. 20).

- The point group symmetry of an ideal, flat, two dimensional monolayer of boron nitride with threefold coordinate boron and nitrogen atoms is D3h, that of an ideal graphene layer is D6h. Thus, this idealized building block of a BN monolayer built up from threefold coordinate boron and nitrogen atoms, forming a hexagonal Bravais lattice, but the term "hexagonal boron nitride", if used for the description of those monolayers, is misleading for the above mentioned reasons.

- Furthermore, regarding the BN modifications consisting of fourfold coordinate boron- and nitrogen atoms like cubic and wurzite BN, the latter has also a hexagonal crystal symmetry and is in some cases referred to as a "hexagonal boron nitride" modification, but has a totally different atom connectivity if compared to a BN monolayer.

Therefore, an appropriate term has to be used to describe these boron nitride monolayers consisting of a network of threefold coordinate boron and nitrogen atoms.

The carbon system reveals a manifold of structural analogons of the isoelectronic BN system (e.g. diamond / c-BN; londsdaleit / w-BN; graphite / h-BN or r-BN, cf. Fig. 20). The individual building blocks of a graphite crystal are generally referred to as graphene layers in the literature.

The two-dimensional graphene-like BN monolayers are built up by a two-dimensional array of individual BN units, which resemble the smallest building block in this system, leading to a graphene isostructural motif. For reasons mentioned above, and since the individual building block of a two-dimensional BN layer of hexagonal (or even rhombohedral) boron nitride is a boronitrene unit (which may be considered in chemical terms as a molecular unit linking a borylene with a nitrene), these layers, which resemble the analogy to graphene layers, will be referred to in this description as boronitrene layers.

Thus, a boronitrene film or layer as referred to in this invention has the following properties:

- It is a monolayer consisting of threefold coordinate boron and nitrogen atoms of an idealized B : N ratio of 1:1 (not considering rim effects, which may alter the idealized stoichiometry by linkage to any heteroatoms).

- The lateral dimension of those films may start from at least one six membered $B_3N_3$-ring, which may be extended by individual BN units to any size.

- The boronitrene monolayer may be planar, or bulged or regularly or irregularly undulated or corrugated, leading to a reduced symmetry (e.g. distortions) of the idealized system. The idealized boronitrene film is the inorganic counterpart to graphene and resembles a building block of the BN bulk modifications h-BN or *r*-BN, as depicted in Fig. 20

The term boronitrene film may be used according to the invention for any type of a monolayer of BN films consisting of threefold coordinate boron and nitrogen atoms, which may not necessarily reveal an epitaxial relation to a substrate, as e.g. by arbitrary orientation of the boronitrene domains on the surface

In the following, the term "boronitrene" is used according to the invention in analogy to the term "graphene" to describe the monolayer of BN having a hexagonal honeycomb structure formed by the N and B sublattices. "Boronitrene" then corresponds to one layer of h-BN crystal structure perpendicular to the c-axis (h-BN monolayer).

The term metal nitrides encompasses, according to the invention, preferably highly ordered metal nitrides, particularly preferably boronitrene layers as defined above.

M is selected from the acidic metals B, Al, SI, Ge, Sn, Ti, Zr, Hf, the lanthanides, the actinides and the transition metals. Preferably, M is selected from B, Ti, Zr, Hf, and most preferably M is B.

The claimed process comprises a conventional step a) of providing a thin nitride layer by CVD or PVD (e.g. molecular beam epitaxy, electron beam evaporation, thermal evaporation, Laser ablation or sputtering), e.g. in the case of boron nitride by CVD of borazine or trichloroborazine. This procedure is known in the art.

The nitride layer is deposited on a substrate. All layers described in this invention can be grown on any substrate that is in accordance with the described mechanisms, preferably a rhodium surface in (111) orientation, either as a single crystal or as an epitaxial layer. In the following these surfaces are labelled as Rh(111).

The use of crystalline Rh(111) surfaces (either as a single crystal or as an epitaxial layer) was caused due to experimental reasons in order to have experimental access to some of the phenomena described in the invention, as, e.g., the probing of surface structures by scattering techniques such as Low Energy Electron Diffraction (LEED) or X-ray Photoelectron Diffraction (XPD).

The decay/growth mechanisms described in the invention are, however, not restricted to crystalline surfaces to get boronitrene layers. The presented reaction mechanisms are also valid for amorphous or polycrystalline surfaces, and thus these surfaces may also be used as substrates according to the invention.

Preferably, the substrate has a surface of hexagonal or pseudohexagonal symmetry (according to the invention, the term pseudohexagonal refers to slightly distorted hexagonal symmetry, as, e.g., in the case of the (110) surface of a body-centered cubic lattice), more preferably a (111) surface of face-centered cubic crystals or a (0001) surface of hexagonal crystals. In the Examples described below the use of crystalline surfaces is just due to experimental reasons to detect the surface structure by scattering techniques. From the chemical experiments mentioned above it is obvious that the described mechanism and the claimed process also works on amorphous or polycrystalline surfaces, such as glass surfaces. Other substrates, which may be used according to the invention, can be any type of metal films, ceramic materials, or metallic or non-metallic glasses or any layered components thereof.

The substrate can preferably be selected from the 3d, 4d or 5d metal rows of the Periodic

Table and preferably has a hexagonal or pseudohexagonal surface structure, e.g. Rh(111), Ru(0001), Ag(111), Cr(110), Pt(111), Pd(111), Ni(111),) Mo(110), whereas the bonding strength between boronitrene and the metal surface decreases within each row with increasing number of d electrons, and is largest for the 4d row, as theoretically predicted by Laskowski et al. (R. Laskowski et al., Phys. Rev. B 78, 045409 (2008)). Since single cystals are not preferred for industrial production for economic reasons, the experiments described below in the Examples have been performed by using an epitaxial Rh(111) film on a Si(111) based multi-layer substrate as described by S. Gsell et al (J- Crystal Growth 311 (2009) 3731 and shown in F. Müller et al., Surf. Sci. 603, 425 (2009). Thus, this Rh-YSZ-Si(111), wherein YSZ means "yttrium-stabilized zirconia" can be used preferably..

The conventional CVD of borazine or trichloroborazine of step a) is carried out under the following conditions:

After the surface of the metal substrate (preferably single crystal or epitaxially grown metal layer) has been cleaned by standard procedure (e.g. by Ar ion etching in UHV (ultra-high vacuum) and subsequent annealing in $O_2$ atmosphere, about $10^{-7}$ to $10^{-6}$ mbar for approx. 1 min.), borazine or trichloroborazine is provided by a nozzle via an inlet valve at a pressure in the range of about $10^{-8}$ mbar to $10^{-6}$ mbar for about 1 min while the substrate is set to 900 K-1100 K (cf. F. Müller et al., Surf. Sci. 603, 425 (2009)).

With respect to reproducibility pressure must be considered as an apparatus specific parameter. The pressure rather refers to the reading of the applied gauge (here a Bayard Alpert gauge) than to an absolute value. This value cannot be adapted directly to another apparatus. Thus, any pressure values given in the present description can just serve as a guide. Working with another setup will then require an optimization of the parameter to obtain the specific results. This adaptation is within the usual practice of the one skilled in the art.

It has to be noted that for all CVD, oxidation/nitrification and annealing steps performed according to the present invention, the conditions such as time, pressure and temperature are not critical and are selected by the one skilled in the art appropriately. The values specified in this description are merely given as illustration and can be adapted appropriately.

Optionally, an annealing step can be carried out after formation of the MN, preferably BN layer and before oxidation, that is, between step (a) and (b). The annealing is carried out e.g. by heating at 900 K - 1000 K for about one to several hours.

Then, according to the inventive process, the obtained nitride layer is oxidized, usually using oxygen gas, under the exemplary conditions about 55 L $O_2$ at 2.5 •$10^{-7}$ mbar for 300 sec. at 900 K. Oxygen ($O_2$) or any other gas leading to an oxidation of the boride layer can be applied (e. g. ozone). Mixtures of these oxidizing gases containing any of these reactive gas components may also be applied for the steps. Additionally, inert gases may be present in the gas used for oxidation, such as noble gases such as Argon or any gas not participating in the reaction itself. This oxidation may be carried out in one step or in several steps.

Subsequently, a nitrification step is carried out using a nitrogen-containing gas, preferably nitrogen or ammonia, for obtaining a highly-ordered nitride layer. Mixtures of nitrogen-containing gases may be used as well. Further inert

gases as specified above may be present. The conditions for the nitrification step (c), given as an example, usually are about 91 L $NH_3$ at $4 \cdot 10^{-7}$ mbar for 300 sec at 900 K.

The gases used according to the invention preferably are highly pure gases having a purity higher than 99%; in the Examples, purities of 99.998 % for oxygen (oxygen 5.8) and 99.98 % for ammonia were used.

If desired, a final annealing step (d) can be carried out using the conditions 900 - 1100 K for one to several hours.

Preferably, the obtained metal nitride layer, in particular boronitrene layer is a monolayer.

In general, according to the invention a monolayer is defined as a flat, bulged or corrugated layer with a thickness of the base of the Bravais lattice. In the particular case of boronitrene, there is an in-plane orientation of the base so that the layer has a thickness (or local thickness in case of corrugated or bulged layers) of one atom. The existence of a monolayer can be confirmed by the appearance of the superstructure spots in Low Energy Electron Diffraction (LEED) that immediately display the lattice mismatch of the interface. For a qualitative analysis, the thickness of the metal nitride layer, in particular the boronitrene layer, can be estimated by the attenuation of the substrate signals in X-Ray photoelectron spectroscopy (XPS) or X-Ray photoelectron diffraction (XPD), as described in Figs. 7 and 11.

Preferably, according to the invention essentially the complete surface of the substrate is covered by the monolayer. However, also embodiments are comprised by the present invention wherein parts of the surface, e.g. more than 50 % or preferably more than 60 % of the surface are covered by the metal nitride monolayer, in particular boronitrene monolayer.

Especially in the case of low deposition doses, as, e.g., for low preparation pressures and/or for short preparation periods, the substrate does not have to be covered completely by the layer. In this case, a coverage or thickness given in fractions m of a monolayer means that only a fraction m of the substrate is covered by the layer of average thickness of one monolayer.

If desired, the substrate, in all embodiments of the invention, may be cleaned and annealed before carrying out step (a) descried before or (a*) described below. Such cleaning can be carried out, e.g., by $Ar^+$ etching, the annealing by heating in oxygen at e.g. 900 K. Other standard procedures for obtaining an atomically clean surface are known to the one skilled in the art.

Surprisingly, by the inventive process comprising the oxidation and subsequent nitrification, an even more highly ordered nitride, in particular boronitrene, structure can be obtained than the original nitride structure provided by conventional CVD.

In a specific embodiment, the inventive process is described for obtaining a boronitrene layer in the following.

First, the reactivity and chemical stability of a boronitrene film grown by CVD of borazine on an epitaxial Rh (111) substrate (F. Müller et al., Surf. Sci. 603, 425 (2009)) was investigated by LEED (low energy electron diffraction) and XPS (X-ray photoelectron spectroscopy) with respect to the formation of intermediates and the reactivity of newly formed species.

It can be commonly observed that the oxygen content of BN monolayers prepared from borazine determined by XPS dropped significantly even beyond the detection limit, after a BN layer had been formed. For these reasons the inventors assumed that oxygen-containing compounds in the B-N-O-H- system can act as surfactants delivering mobile species responsible for the BN- layer formation.

In order to validate this aspect, the following experimental sequence using LEED and XPS analysis was performed to learn more about the stability and growth of BN. The results of the sequence (LEED polar intensity plots and relevant XPS signals) are depicted in Fig. 17. They indicate the formation of a structured BN superstructure by CVD of borazine, the formation of an unstructured film containing boron and oxygen after oxidation, and the reformation of a BN superstructure after adding ammonia to the system.

In the first step, a boronitrene monolayer was prepared by CVD of borazine as previously described (M. Corso, supra) and the formation of the BN superstructure was confirmed by LEED (low energy electron diffraction) and XPS data (Fig. 17, 1st row). In the second step, oxygen was added at 900 K to see whether the obtained BN superstructure remains stable. Since this was not the case, but the formation of an unstructured boron oxide species was detected on the substrate as indicated by LEED and XPS measurements (Fig. 17, 2nd row), the question of the reversibility of such a reaction sequence has arisen. Therefore, in the next step, ammonia was added at 900 K and remarkably, XPS signals for boron B1s and nitrogen N1s appeared again, while the intensity for 01s had decreased and the LEED pattern began to indicate a reformation of the original BN superstructure (Fig. 17, 3rd row). Further addition of ammonia showed that the oxygen content could be decreased more significantly (Fig. 17, 4th row). In the fifth step, only an annealing was performed leading to the original BN superstructure again and a reduction of the oxygen content in the film beyond the detection limit (Fig. 17, 5th row). The details of this reaction sequence are described in the Examples given below.

The inventors performed a further experiment which clearly demonstrates the role of mobile $BN_x(NH)_y(NH_2)_zO_a(OH)_b$ species. The numbers x, y, z, a and b depend on the ring perimeter of the domain size of the boronitrene layer and cannot be specified in detail and may be present in various fractions. These species for a nitride based ceramic material strongly indicate the kinetic growth effects. The experiment showed the stability and reversibility of the formation of boron nitride in the system borazine/metal substrate, as well as boron oxide/ammonia/metal substrate. The oxidation

reaction of the boronitrene layer can formally proceed in several ways, formally leading to the formation of boron oxide and dinitrogen

$$BN+1.5O_2 \rightarrow 0.5B_2O_3+0.5N_2$$

or even to an oxidation of nitrogen to NO or $NO_2$, depending on the amount of oxygen and reaction conditions:

$$BN+2O_2 \rightarrow 0.5B_2O_3+NO \text{ or } BN + 2.5O_2 \rightarrow 0.5B_2O_3+NO_2$$

The latter reactions may be more likely due to mechanistic reasons. Since the boronitrene layer has separated boron and nitrogen atoms, formation of dinitrogen will only take place if two isolated nitrogen atoms will form dinitrogen on the degrading surface, but a catalyzed oxidation to NO and $NO_2$ may be kinetically favored. Nevertheless, an unstructured boron oxide film remains on the substrate, as indicated by the XPS and LEED data in Fig. 17. The reformation of boron nitride through treatment of the remaining $[BO_x(OH)_y]$ film with ammonia leads to the elimination of water and finally the formation of boron nitride (cf. XPS and LEED patterns in Fig. 17).

Mobile molecular species are necessary to enable the BN formation in this B-N-O-H- system. These are for example molecular diborontrioxide, $B_2O_3$, boroxylamine $O=B-NH_2$, diboroxylamine $(O=B)_2NH$, trisboroxylamine $(O=B)_3N$ and trishydroxylborane, $B(OH)_3$, and isomers and oligomers of the latter compounds like, e.g., HN=B-OH, borazines or boroxines. It has to be noted that the parent compounds of B,B',B"- Tris( ydroxyl)borazine and B,B',B"-Tris (amino)boroxine, both instable molecules, have the same stoichiometry and can formally be interconverted into each other, as has been found by one of the inventors. Such an equilibrium of hydroxyborazines and aminoboroxines is depicted in the following scheme 1 and has not been described in literature before.

Scheme 1: Hydroxyborazine- Aminoboroxine Equilibrium

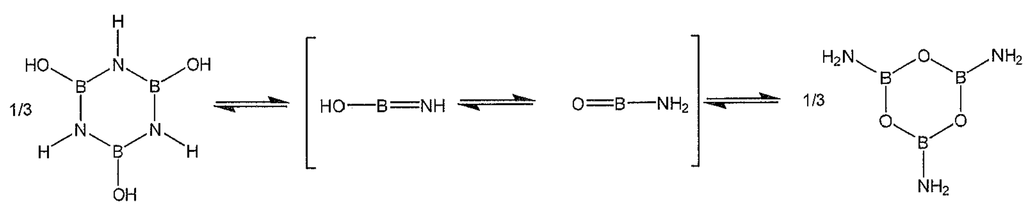


These molecular compounds are mobile and fluctional, tend to polymerize by condensation and can enable rim reactions on boronitrene layers while being templated on a substrate surface, as depicted in Fig. 18 ("surfactant type reactions").

Additionally, an experiment was performed, which is summarized in Fig. 19. It clearly demonstrates the role of mobile species for a nitride-based ceramic material. From the presented results, it is evident that kinetic growth effects are responsible for the oxidation and nitrification reactions. Thus, the interface between the gas phase and the growing BN-film is mediated through a region of highly mobile and reactive species. This experiment clearly demonstrates that the precursor chemistry is not responsible for the formation of two-dimensional BN networks, but surfactant type reactions allow the formation and dissolution of boronitrene layers.

The role of oxygen compounds, generally present on a metallic substrate as oxide- or hydroxyl-type surface terminations, residual adsorbed dioxygen or water, or background gas pressure, can be regarded as a surfactants in the case of the formation of boron nitride, leading to a chemical saturation of the peripheral rim of the individual boronitrene layers, as schematically represented in Fig. 18. The presented results prove that the formation of a boronitrene monolayer on the substrate is governed by a surfactant type reaction. It could be demonstrated that oxygen has a significant influence on the reversible formation of boronitrene layers and can act as a surfactant towards the formation of BN.

The inventors' above-described experiment shows that the solid boronitrene monolayer is built up by a highly anisotropic reaction controlled by reactions at the rim of the layer and the presented XPS data clearly indicate a reversible formation of boron nitride from a boron-oxygen system through a substrate templated reaction not involving boride species, since these signals would be detectable in a region lower than 190 eV (H.C. Hamaker et al., Phys. Rev. B, 27 (11) (1983) 6713).

The inventors could thus demonstrate that a BN superstructure is converted into an unordered boron oxide film by an oxidation process and that the resulting boron oxide film can be reconverted into a pure boron nitride (boronitrene) film through treatment with ammonia, which was verified by XPS and LEED.

These results demonstrate the importance of $B_xN_yO_z(OH)_a(NH)_b(NH_2)_c$-species for the buildup and degradation of boronitrene layers. Since these boronitrene layers are highly anisotropic, the dominant reactions for the buildup and

degradation take place at the peripheral rim of the boronitrene layers. Highly mobile species like $B_2O_3$, $H_2NBO$, HOBNH, $HN(BO)_2$, $N(BO)_3$ and higher aggregation forms of these species (cf. Scheme 1) can act as mobile intermediates on the peripheral rim of the boronitrene layers, leading to a buildup or a degradation of the individual layers. A structural motif of such a peripheral rim with reactive sites of a boronitrene layer is depicted in Figure 18. The presence of highly mobile $BN_x(NHMNH_2)_zO_a(OH)_b$- species on the substrate could also be verified, since a mere annealing process of a partially nitrified B-N-O-H-film (cf. Fig. 17, 4th row) leading to a complete reduction of the oxygen content beyond the XPS-detection limit and enables the regeneration of a highly ordered boronitrene superstructure.

A good boron and nitrogen containing support species like the borazine precursor molecule has proven to allow an easy access to the generation of boronitrene layers.

The present results explain why the formation of thick highly ordered crystalline boron nitride films is difficult to achieve, since the newly formed BN surface leads to totally different sticking coefficients for the active growth species compared to the metal substrate.

Thus, the first embodiment of the invention described above provides a process for forming highly ordered thin layers, in particular monolayers, of metal nitride, preferably boronitrene, by oxidation and nitrification of a conventionally prepared metal nitride.

In a second, preferred embodiment, which is defined in claim 8, a two- or three-step boration-(oxidation)-nitration process is provided that finally results in metal nitride, preferably boronitrene monolayers of very high quality by using acidic metal alcoholates, preferably boric acid derivatives, in particular $B(OR_3)_3$, preferably trimethylborate $B(OCH_3)_3$, an oxidizing gas such as oxygen ($O_2$), a nitrating gas such as ammonia ($NH_3$) or $N_2$ for formation of a metal nitride layer, preferably a boronitrene layer on a substrate.

In this embodiment, step(a) of the process described before in this embodiment is replaced by step (a*).

This step (a*) uses a different precursor for finally obtaining the nitride layer than in the first embodiment, namely an alcoholate of an acidic metal. The suitable precursors are selected from $M(OR)_x$, wherein M is selected from B, Al, Si, Ge, Sn, Ti, Zr, Hf, the lanthanides, the actinides and the transition metals. Preferably, M is selected form B, Ti, Zr, Hf, and most preferably M is B. OR is an alcoholate having an $\alpha$-H functionality. Preferably R is a linear or branched $C_1$-$C_{12}$ alkyl, which may optionally be substituted by halogen, alkyl or aryl, and x is an integer according to the valency of M.

Alkyl in this invention is linear or branched $C_1$-$C_{12}$ alkyl, or cyclic $C_3$-$C_7$ alkyl. Aryl means monocyclic or polycyclic aryl, e.g. $C_6$-$C_{22}$ aryl. Halogen means fluoro, chloro, bromo or iodo.

If more than one R is present in the compound $M(OR)_x$, then the Rs may be the same or different.

Preferably, the precursor is $B(OR)_3$, wherein R is defined as before, and even more preferably $B(OMe)_3$.

The substrate is identical to that of the first embodiment.

The CVD using the above-mentioned precursor is carried out at e.g. at a substrate temperature of 800 K. The deposition dose of metal alcoholate, preferably trimethylborate is e.g. 150 L (pressure $4.4 \cdot 10^{-7}$ mbar for 450 sec.)

Steps (b), (c) and optionally (d) as well as another optional annealing after formation of the starting nitride layer are carried out as described before for the first embodiment of the invention.

It is also possible, in this embodiment of the invention, to directly carry out the nitrification step (c) after step (a*), that is, without carrying out the oxidation, as has been shown in the Examples described below.

It is assumed that by annealing, before the optional oxidation step, an anisotropic segregation of M atoms, e.g. B atoms, directed to the surface of the substrate is induced.

The second embodiment of the invention is explained by formation of a boronitrene layer as an example in the following.

The formation of well-ordered monolayers of boronitrene on an epitaxial Rh(111) surface substrate via a boration-oxidation-nitrification process according to the second embodiment of the present invention was investigated by X-ray photoelectron spectroscopy (XPS), X-ray photoelectron diffraction (XPD) and low energy electron diffraction (LEED). The unusual decomposition of trimethylborate $B(OCH_3)_3$ by a CVD reaction offers a new route to the deposition of boron and formation of intermetallic borides and access to metal- boron-carbon- nitrogen films of transition metals in different stoichiometrics.

The observed decay of trimethylborate is not described in literature so far.

The CVD of trimethylborate results in a complete decomposition of the precursor with a dilute distribution of boron within the intersticials of the metal lattice. After oxidation, the resulting boron oxide layer of about 1 nm thickness can be transformed into a monolayer of boronitrene by annealing in $NH_3$ atmosphere. However, each single step of the process leads to interesting intermediate products which are also claimed in the invention.

This procedure according to the second embodiment represents an alternative routine for the preparation of well-ordered metal nitride, preferably boronitrene monolayers, which benefits from a strong reduction of hazardous potential and economic costs compared to the use of borazine or trichloroborazine as the current standard precursors. Both aspects as well as the easy handling of the preparation represent decisive factors especially with respect to wafer-size mass production of boronitrene layers.

The invention further relates to an article having a thin nitride layer, preferably a monolayer, obtainable by the

processes according to the two embodiments of the invention described before.

Further, the invention provides the use of a thin nitride layer, preferably a boronitrene layer, obtained by the processes according to the two embodiments of the invention described before, in the manufacture of electronic devices, such as nano-electronic devices. Currently, it is believed that in future electronic devices silicon will be replaced by graphene due to its outstanding electronic properties. Especially the combination of graphene as a semimetal or semiconductor and the isotructural boronitrene as an insulator are expected to form the fundamental ingredients for the engineering of nano-transistors (A. Geim, K. Novoselov, Nature Materials 6 (2007) 183).

In a third embodiment, the invention provides a process for hardening the surface of a substrate as defined before, the process comprising carrying out step (a*) as defined in the second embodiment on a substrate. Thereby, metal atoms M as defined before, preferably B atoms, are finely dispersed or "implanted" in the surface, e.g. a crystalline or epitaxial Rh(111) surface, and provide a surface in a thickness of nanometers (at least 2 nm as the probing depth in XPS). Thus, the process defined in claim 8 is stopped after step (a*) in this embodiment of the invention, and the intermediate product of the second embodiment is obtained as a hardened substrate. This intermediate product is claimed in claim 20 and is an object of the invention.

In a fourth embodiment of the invention, the thus obtained intermediate product after step (a*) is oxidized, that is, step (b) is carried out, optionally after an annealing step by heating. Thus, in this embodiment the process of the second embodiment is stopped after step (b), and a second intermediate product is obtained. This product has a thin oxygen compound layer having a thickness of approx. 1 nm. This product is a further object of the invention and is defined in claim 21.

The use of the thus obtained thin oxygen compound layer in an electronic or preferably nano-electronic device, e.g. as an insulating buffer layer, is also an object of the invention defined in claims 22 and 23.

Additionally, in a fifth aspect, the invention provides an article, comprising an epitaxial Rh(111) surface, and, provided thereon, a hardened surface or a thin oxygen compound layer, as claimed in claim 25, and the use of such substrate in a process of one of the embodiments of the invention as described before, defined in claim 25.

In this invention, it was shown that the preparation of well-ordered boronitrene monolayers is possible by a two or three-step boration-(oxidation)-nitrification process by using low cost standard chemicals. This recipe is interesting since it is expected that the engineering of future electronic devices will require a large-scale production of boronitrene layers because then, the use of borazine or trichloroborazine precursors will cause several problems, such as high costs, difficult synthesis, long-term stability and high risks. However, even apart from those "economic" and safety aspects, each individual step of the boration-oxidation-nitration process is of particular interest:

(i) The full decomposition of the $B(OMe)_3$ precursor offers an easy access for embedding single boron atoms within the lattice of a metal substrate, a procedure that offers the possibility to prepare boride surfaces for wear resistant materials. This mechanism is also valid for similar precursors, containing hafnium, titanium, zirconium, etc.

(ii) The oxidation of the B-metal surface (here: B-Rh) results in a boron oxygen compound layer of a thickness of about 1 nm that can act as a small insulating barrier in a nano-electronic device.

(iii) the transformation of the boron oxygen compound layer into a boronitrene monolayer by nitration offers the possibility for large-scale, wafer-size production of well-ordered boronitrene layers.

Finally, it has been found surprisingly that the decomposition processes of the precursor described before can be used for obtaining aldehydes/ketones in a decomposition reaction with a transition metal surface. This provides a sixth aspect of the invention.

The experiments [decay of trimethylborate [$(MeO)_3B$] described in the Examples reveal the following facts as indicated by the XPS- and LEED data:

The substrate is clean with respect to oxygen and carbon impurities, as indicated in Fig. 2; (the latter are ubiquitous and usually accumulate during typical UHV experiments). The decay of trimethylborate leads to the formation of a Rh- boride film with boron atoms located in interstitial sites, as indicated by the XPD measurements in Fig. 4. This film strikingly does not contain any oxygen as per XPS measurements or a significant amount of carbon (the carbon found is below 4% of the amount which results from the amount of boron from the precursor).

These three striking and unexpected facts - no oxygen and no significant carbon deposition and formation of a Rh- B- film - can be interpreted by a selective decay mechanism of the trimethylborate precursor by formation of intermediate species containing a boron compound leading to the formation of the boride film and volatile C-H-O species leading to a removal of carbon and oxygen.

Such a decay is feasible by a dehydroboration reaction of trimefihylborate leading to the elimination of a carbonyl

species (e.g. in the case of trimethylborate $CH_2O$) and the intermediate formation of boron hydrides. The former species can be considered responsible for the removal of carbon and oxygen, whereas from the latter intermediate, the formation of the boride film is feasible as observed in the experiment.

Any other decay mechanism involving a retention of a boron oxygen bond, which formally might be expected according to the bond energies for the individual bonds, would lead to boron- oxygen containing species on the substrate instead of the observed rhodium- boride film. A formally radical type cleavage of the B-O bond is not compatible with observed reactions mechanisms in boron chemistry under the conditions applied in the experiment because of the large B-O bond energies.

The obtained rhodium boride film can be oxidized to an unstructured B-O- film and transformed to a highly structured boronitrene film by nitrification with ammonia by selective gas reactions, as described above.

A reaction scheme describing this decay is depicted in equation 1:

Equation 1: Reaction sequence of the precursor decay:

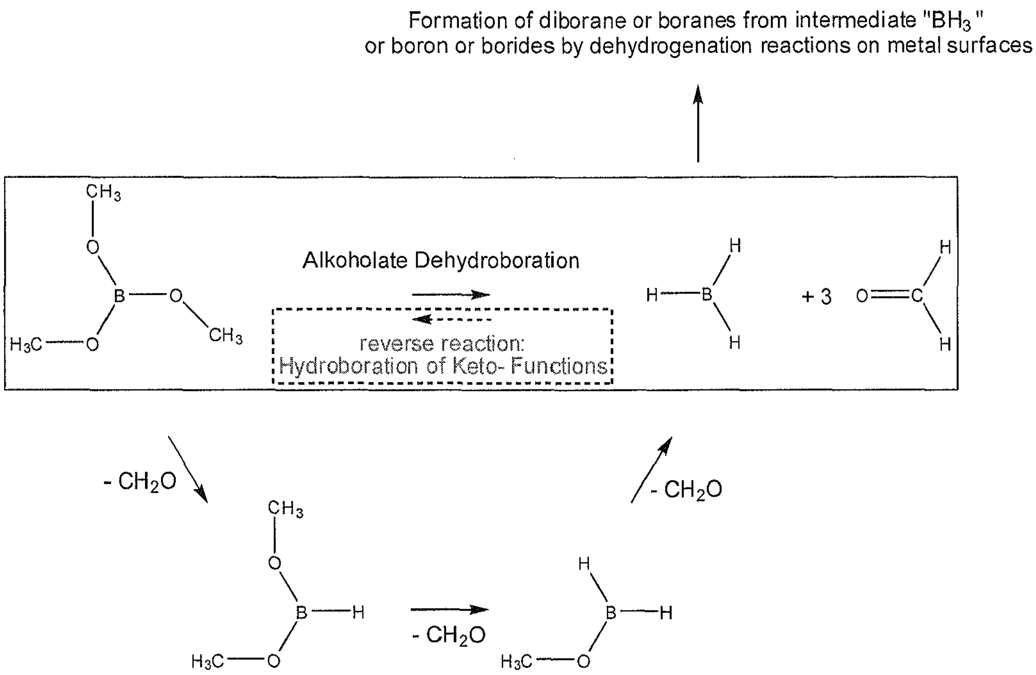


The transition metal substrate may be responsible for the lowering of the activation energy for the alcoholate dehydroboration reaction.

Thus, the process according to the invention is carried out by CVD of a suitable metal alcoholate as defined before in the presence of a substrate as defined before.

Although the bond energies would imply a retention of the B-O bond by fragmentation of the precursor, formation of elemental boron from a formally totally oxidized boron species is observed. The reaction sequence explaining the experimentally verified results is a reaction mechanism unobserved so far. The observed reaction (decay of trimethylborane or corresponding alcoholates) can be interpreted as a dehydroboration of a carbonyl function, thus enabling the formation of intermediate metal hydrides as well as molecular building blocks with selectively substituted carbonyl functions. Such a decay mechanism is in general feasible with any metal center of appropriate acidity linked to an alcoholate with $\alpha$-CH-functionality and can be considered as a alcoholate dehydrometallation reaction leading to a metal hydride and the corresponding keto species as per equation 2:

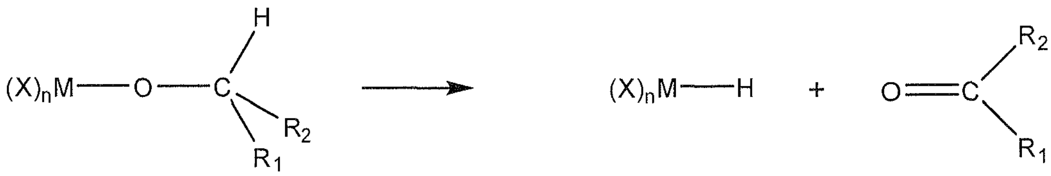

(eq.2)

$R^1$, $R^2$ = aryl, alkyl or $R^1$ = aryl, alkyl and $R^2$ = H; X= any type of substituent, e.g. halogen, alkyl, aryl , M = any type of acidic metal, preferably B, Al, Ga, Si, Ge, lanthanides, transition metals, most preferably B.

The reaction itself according to the invention is catalyzed by transition metal surfaces, as defined before, preferably surfaces having a hexagonal structure such as a (111) surface of a face-centered cubic lattice or a (0001) surface of a hexagonal lattice, preferably a Rh(111) surface, which also serves as a substrate for the generation of a rhodium boride layer in the experiments described in this invention. A more generalized equation is given in eq. 3:

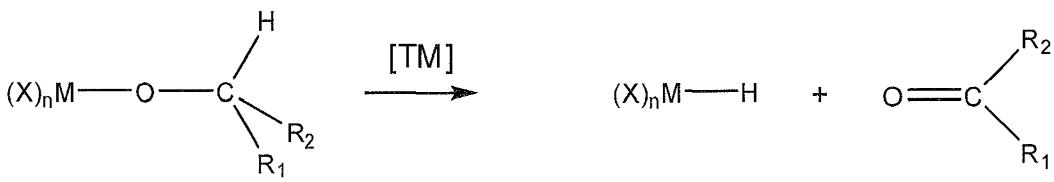


(eq. 3)

$R^1$, $R^2$ = aryl, alkyl or $R^1$ = aryl, alkyl and $R^2$ = H; X= any type of substituent, such as halogen, alkyl, aryl; M = any type of acidic metal, e.g. B, Al, Ga, Si, Ge, lanthanides, transition metals

This type of dehydrometalation reaction can be carried out, besides with boron, with other acidic metals like Al, Ga, Si, Ge, lanthanides and transition metals, e.g. like titanium or hafnium according to the invention.

**Description of the figures**

**Figure 1**

Part a) shows the experimental setup as described in the description.

Part b) shows the structure of a [111] surface of a face centered cubic crystal lattice. The $[\bar{1}\bar{1}2]$ and $[11\bar{2}]$ directions refer to the symmetry axes in $\underline{k}$-space with first-order spots.

Part c) shows the molecular structure of trimethylborate $B(OCH_3)_3$.

**Figure 2**

The XPS data (Al-$K_\alpha$, $\hbar\omega$ = 1486.6 eV) for C-1s, O1-s and B-1s for clean sample (bottom) and after deposition of 150 L $B(OCH_3)_3$ at 800 K (top) with intensities normalized to atomic ratios are shown. The shaded areas represent the intensities, as expected if the data display the full stoichiometry of the precursor. Due to the only slight increase of C-1s intensity and due to the vanishing O-1s intensity, a complete decomposition of the precursor can be expected.

**Figure 3**

The figure shows the angular intensity distributions (XPD) of Rh-3d photoelectrons (clean sample) and B-1s photoelectrons (after deposition of 150 L $B(OCH_3)_3$ at 800 K) in the [112] - [111] - [112] plane, with surface normal along [111]. The Rh-3d intensity displays the forward scattering from the corresponding lattice plane, cf. cross section of lattice structure (the hollow circles represent Rh atoms from the neighboring planes). The B-1s intensity mainly displays rather the forward scattering from the tetrahedral sites (T1, T2) than the scattering from the octahedral sites (O1, 02).

**Figure 4**

XPS data (Al- $K_\alpha$, $\hbar\omega$ = 1486.6 eV) for a) C-1s, b) Ol-s and c) B-1s during oxidation of the B-Rh surface with intensities normalized to atomic ratios are shown. The oxygen dose in L is given by the numbers in b). After applying 50 L $O_2$, an additional B-1s intensity appears at 193 eV due to the formation of boron oxide while the initial B-Rh intensity slightly shifts to higher binding energies due to embedding of oxygen in the Rh lattice (dilute Rh-B-O). With increasing $O_2$ dose, the B-1s intensity is systematically shifted to the boron oxide peak. Throughout the whole series, the C-1s intensity is at the detection limit.

**Figure 5**

Figure 5 shows the quantitative analysis of the O-1s and B-1s intensities from Fig. 4. With increasing oxygen dose, the intensities from O-1s and the boron oxide related part ($B_{Ox}$) of B-1s in a) are running parallel, while the B-Rh related part ($B_{met}$) of the B-1s intensity starts with constants values and finally drops to zero (grey lines are just a guide to the eye). In b), the ratio of O-1s intensity and boron oxide related B-1s intensity approaches a 2:1 distribution, indicating the formation of a $BO_2$ species, such as metaboric acid. With increasing oxygen dose, the whole B-1s intensity from $B_{met}$ is transformed to B-1s intensity from $B_{Ox}$.

**Figure 6**

Molecular structures of a) orthoboric acid and b) metaboric acid with similar oxygen configuration of the boron atom, but different B:O ratios, 1:3 in a) and 1:2 in b), are shown respectively. According to the results from Fig. 5, the formation of a glass-like layer by metaboric acid is expected.

**Figure 7**

Figure 7 depicts an approximation of the thickness of the boron oxygen compound layer by the attenuation of photoelectron intensity of the Rh surface. In a), forward scattering from the crystalline Rh surface is reduced by using electrons with small kinetic energies (here Rh-MVV Auger electrons, $E_{kin}$~300eV) at full angular apertures and by azimuthal averaging of the $2\pi$ diffraction patterns (grey dots). In b), the ratio of the azimuthally averaged polar distributions is compared to the factor $\exp(-d/A\cos\vartheta)$ for $d/\lambda$ ranging from 0 to 1 (in steps of 0.1) with d describing the thickness of the oxide layer and $\lambda$ describing the mean free path of the electrons (~ 1 nm). The thickness of the oxide layer can be approximated as d ~ 8 Å ~ 1 nm.

**Figure 8**

X-ray photoelectron diffraction (XPD) patterns (Al-$K_\alpha$, stereographic projection) of a) Rh-MVV Auger, b) O-1s and c) B-1s for ~ 1 nm boron oxide on Rh-YSZ-Si(111) are shown in this figure. In contrast to the Rh intensity in a), the O-1s and B-1s intensities in b)-c) display no distinct intensity modulation due to forward scattering, indicating the absence of crystalline order in the glass-like boron oxide film.

**Figure 9**

XPS data (Al-$K_\alpha$, $\hbar\omega$ = 1486.6 eV) for a) C-1s, b) O1-s, c) N-1s and d) B-1s during nitration of the boron oxide surface with intensities normalized to atomic ratios are shown. The $NH_3$ dose in L is given by the numbers in c). With increasing $NH_3$ dose, the O-1s intensity in b) decreases as the N-1s intensity in c) increases, while the B-1s intensity from the boron oxide at ~ 193 eV is completely transferred to 190.6 eV as characteristic for the formation of BN. Throughout the whole series, the C-1s intensity in a) is at the detection limit.

**Figure 10**

Part a) depicts a quantitative analysis of the O-1s (square), B-1s (triangle) and N-1s (circle) intensities from Fig. 9. With increasing $NH_3$ dose, the O-1s intensity monotonically drops to zero, while the B-1s and N-1s intensities approach a common value (grey lines are just a guide to the eye).

Part b) indicates the formation of boron nitride BN by the B:N = 1:1 ratio.

**Figure 11**

This figure depicts an approximation of the thickness of the boron nitride layer by the attenuation of photoelectron intensity of the Rh surface. a), same as in Fig. 7 a) for clean and BN-covered substrate, b), same as in Fig. 7 b). Here, the experimental intensity ratio results in a thickness of about d ~ 2 Å for the BN layer.

**Figure 12**

LEED patterns of a) clean Rh-YSZ-Si(111) surface, b) after formation of ~ 1 nm glass-like boron oxide layer and c) after formation of ~ 1 monolayer boronitrene after nitration of b) are shown. The formation of the boronitrene/Rh (111) Moiré pattern is seen by the additional six-fold intensity distribution of non-integral spots around the principal spots, see also d).

**Figure 13**

Shown is a quantitative analysis of the LEED profiles along the [11$\overline{2}$] direction. In a), the high degree of order for the clean Rh-YSZ-Si(111) surface (top) and the boronitrene/Rh-YSZ-Si(111) surface is displayed by the nearly vanishing background intensities. In contrast, after oxidation, the disordered glass-like boron oxide layer causes the LEED profile (middle) to be dominated by background intensity, b) depicts spot profiles of the (00) spot along [11$\overline{2}$] with non-integral intensities by the boronitrene/Rh superstructure. c) Same as b) for (10) spot. In b)-c), the superstructure spots are distributed rather in fractions of 1/13 (blue lines, 14x14/13x13 superstructure) than in fraction of 1/12 (red lines, 13x13/12x12 superstructure).

**Figure 14**

This figure represents a schematic drawing of the three-step process for boronitrene formation.

**Figure 15**

XPS data (Al-K$\alpha$, h$\varpi$ = 1486.6 eV) for a) C-1s, b) 01-s, c) N-1s and d) B-1s after deposition of $B(OCH_3)_3$ and during nitration within the two-step process without intermediate oxidation with intensities normalized to atomic ratios are given. The numbers in c) indicate the $NH_3$ dose in L. Although BN is formed, it is not possible to extract all of the B-Rh related boron species out of the Rh lattice in d). In contrast to the three-step process, the surfaces exhibits large amounts of carbon impurities in a).

**Figure 16**

The figure shows LEED profiles along [11$\overline{2}$] of a) (00) spot and b) (10) spot after preparation of BN by a two-step boration-nitrification process. Apart from the boronitrene related (10) spot, no additional spot due the formation of a boronitrene/Rh superstructure can be observed, i.e. only the formation of small boronitrene domains is expected.

**Figure 17:** This figure shows LEED- Pictures and XPS- Signals of the described Example 1.

Intensity plots of the LEED Profiles along [11$\overline{2}$]- direction with diffraction patterns of the first order peaks and XPS- detail spectra (O1s, N1s, B1s; A1 K$\alpha$, hv = 1487 eV) of the reaction sequence, from bottom to top:

1) BN superstructure prepared by CVD of borazine
2) oxidation of the BN film and formation of an unstructured boron-oxygen film
3) addition of ammonia: beginning of BN reformation, XPS indicate the presence of B-N-O-(H)- on the surface
4) further addition of ammonia: oxygen content is decreased, BN superstructure formation visible in LEED profile
5) annealing of the film results in a complete elimination of oxygen and reformation of the original BN superstructure

**Figure 18**

This figure shows a surfactant type reaction mechanism of the formation of $sp^2$-type BN layers. A reaction of an unstructured boron oxide film with ammonia leads to a built up of boronitrene layers, leading to NH-, $NH_2$-, B(OH)-, $B(OH)_2$ and $B_2O$- terminated structures, while mobile intermediate species are responsible for the transport of BN- units.

**Figure 19**

Figure 19 gives a summary of the reaction sequence of surface controlled chemical reactions leading to boronitrene. Changes in film structure and stoichiometry observed by LEED are shown.

**Figure 20**

Figure 20 shows hexagonal and rhombohedral BN. The threefold coordinate sp2-type BN-modifications with extreme structural anisotropy are visible. The top left shows a crystal lattice of hexagonal boron nitride (structural data: SG: P 63/m m c (194), a=2.5040Å c=6.6612Å, (H. Sachdev, Diamond and Related Materials 10 (2000), 1390-1397); the top right shows a crystal structure of rhombohedral boron nitride (SG: R 3 m (160), a=2.5040 Å c=10.0000 Å (V.L. Solozhenko et al., Solid State Commun. 90 (1994), 65); the bottom center depicts a boronitrene layer; the bottom left shows a borazine molecule as a molecular building block for a boronitrene layer; the bottom right shows a single boronitrene molecule formally acting as a diatomar building block for polymer two- dimensional boronitrene layers.

## Examples

### Example 1

**Formation of highly ordered boronitrene starting from borazine via oxidation/nitrification**

The epitaxial Rh(111) substrate (Rh-YSZ-Si(111) substrate) was pretreated and cleaned according to F. Müller et al., Surf. Sci. 602, 3467 (2008).

The experiments were performed with a modified VG ESCA MkII spectrometer designed for electron spectroscopy methods such as XPS (x-ray photoelectron spectroscopy), UPS (ultraviolet photoelectron spectroscopy) and EELS (electron energy loss spectroscopy) and their counterparts XPD (x-ray photoelectron diffraction), ARUPS (angle-resolved ultraviolet photoelectron spectroscopy), FSM (Fermi Surface Mapping), LEED (low energy electron diffraction) and AREELS (angle-resolved electron energy loss spectroscopy) using angular resolution. A detailed description of the experimental setup is given in F. Müller et al., Surf. Sci. 602, 3467 (2008).

The sample can be rotated by a XPD-manipulator with two rotational degrees of freedom in experiments involving angular resolution. In this way electrons within the full $2\pi$ hemisphere above the surface of the sample can be detected by a hemispherical energy analyzer. A hemispherical intensity map (XPD, LEED) is recorded by tilting the sample stepwise by the polar angle $\vartheta$ while for each $\vartheta$, the sample is additionally rotated around its surface normal by the azimuth angle $\varphi$ in the full $2\pi$ range. For LEED experiments, the setup is operated in the EELS mode and the intensity $I(\vartheta,\varphi)$ of the elastically scattered electrons at $\Delta E = 0$ is recorded. Contrary to a commercial LEED setup with a fixed direction of the incoming electron beam (usually normal incidence), the present setup records a LEED pattern for a fixed "scattering triangle", thus the scattering angle $\alpha$ between the electron gun ($\Delta E$ = 200 meV at $E_0$= 50 eV and $I_{em}$= 5 nA) and the analyzer is fixed. For this reason, the (00) spot of a normal incidence LEED is replaced by a (00) ring art $\vartheta = \theta/2$ (with $\theta = 180^\circ - \alpha$). The LEED pattern $I(\vartheta,\varphi)$ can be transformed to the more common $I(\Delta q^{II})$ representation by the following equation:

$$\Delta q^{\parallel}[nm^{-1}] = 20 \cdot 0.512 \cdot \sqrt{E_0[eV]} \cdot \cos(\theta/2) \cdot \sin(\vartheta - \theta/2).$$

Substrate pretreatment and preparation of the BN films:

The substrate was cleaned through argon sputtering and a BN film was produced from Borazine as described in F. Müller et al., Surf. Sci. 603, 425 (2009). High purity borazine $(HNBH)_3$ was used as a CVD precursor for the preparation of the BN layers grown by similar procedures as described in the documents mentioned above at a substrate temperature of 900K. The degassed precursor was let into the preparation chamber through a leak valve, with the nozzle placed close to the surface of the substrate. Oxidation experiments were carried out using oxygen 5.8 (purity 99.998 %); nitrification was performed with ammonia 3.8 (purity 99.98 %). These gases were added directly on to the substrate through a leak valve by bypass lines.

An XPS spectrum of the substrate only shows rhodium signals, but no peaks resulting from other impurities like e.g. carbon or oxygen and the corresponding LEED pattern indicates a well-ordered Rh(111) surface The relevant

substrate data correspond to those which are described (F. Müller at al., Surf. Sci. 603, 425 (2009)).

The boron nitride monolayer was generated by addition of 45 L ($p = 4 \cdot 10^{-7}$ mbar for 150 sec) of borazine at 900 K, followed by an annealing at 900 K for one to several hours. The analysis of the LEED pattern and the corresponding polar intensity plots of the (00) and (01) spots displays a halo structure surrounding the principal rhodium reflections, clearly indicating the formation of a commensurate (14x14)BN/(13x13)Rh(111)- superstructure on the Rh(111) terminated substrate surface displayed in Fig. 17, 1st row. The stoichiometry of the superstructure is confirmed by the XPS-data which only reveal signals of boron and nitrogen besides rhodium (B: 190.2 eV, N: 398.0 eV) and a B : N ratio of approx. 1:1, but no traceable oxygen signals.

Oxidation:

This boron nitride monolayer was then allowed to react with 55 L ($p = 2.5 \cdot 10^{-7}$ mbar for 300 sec) of oxygen at 900K. In the corresponding XPS spectrum displayed in Fig. 17, 2nd row,

only signals of boron and oxygen besides rhodium were detected (B1s 191.8 eV, O1s 531.2 eV), whereas the previously present XPS signal of nitrogen fully disappeared. The B1s -XPS signal is shifted towards higher values compared to the previous BN layer. The energies of the 01s- and B1s- signals are in the same region, but not in full accordance with values reported for boron oxide (W. Moddeman et al., Surface and Interface Analysis 14 (1989) 224). The XPS analysis indicates no detectable nitrogen signals but the presence of oxygen and boron in a B: O-ratio of approx. 1:2 (01s 531.2 eV, B1s 191.8 eV). The position of the B1s signal is consistent with boron in the oxidation state +3, and no metal boride formation has occurred, which would be indicated by XPS signals below 190 eV (H.C: Hamaker et al., Phys. Rev. B, 27(11) (1983) 6713).

The B : O- ratio of approx. 1:2 is noteworthy, because it might either indicate an additional absorption of dioxygen on the surface, not being distinguishable by XPS, or, since the presence of hydrogen cannot be excluded from the residual background pressure, indicate the formation of metaboric acid $(HO\text{-}B\text{=}O)_3$, having the said B:O ratio (hydrogen is not detectable with the experimental setup), these findings are also in accordance with the slightly different XPS data compared to boron oxide (W. E. Moddeman, supra). Although boron and oxygen are present on the rhodium surface, the LEED pattern depicted in fig. 17, 2nd row, does not reveal any ordered superstructure on the substrate, and therefore an ordered superstructure resulting from oxygen absorption can be excluded. Since boron oxide, boric acid, as well as metaboric acid display low melting points of 450.0˚C, 170.9˚C and 176.0˚C (F: Hollemann, E: Wiberg, Lehrbuch der Anorganischen Chemie, 91. Ed., W. de Gruyter, Berlin 1985, S. 1104-1108) and tend to form glass like structures and therefore would not give rise to structured LEED patterns, the inventors' observations are in full accordance with these interpretations. In this oxidation experiment, the previously existing BN film could be fully converted into an unstructured film containing boron and oxygen.

Nitrification:

After the oxidation of the boron nitride layer, the sample was exposed to 91 L of ammonia ($p = 4 \cdot 10^{-7}$ mbar for 300 sec) at 900 K, which leads to a change in the XPS spectrum and LEED pattern. The XPS spectrum of the film displayed in Fig. 17, 3rd row, indicates the presence of B, O and N and reveals two signals for the B1s- peak (190.6 eV, 192.8 eV), indicating differently bound boron species. There is also a small shift of the O1s XPS signal detectable (532.4 eV), which may be explained by the formation of B(OH)- groups due to the presence of hydrogen from the reaction with ammonia, while hydrogen was not present in higher concentrations before. Further addition of ammonia (91 L at 900 K) led to a continuous decrease of the 01s- XPS signal intensity (531.6 eV) and the B1s- XPS signals shows an increase of the boron peak attributed to the original BN compound (190.6 eV) and decrease of the intermediate species (192.8 eV). The corresponding LEED pattern indicates the reformation of the original 14x14 BN/13x13 Rh superstructure (Fig. 17, 4th row).

In the next step, a mere annealing process was performed leading to the complete reformation of the original BN superstructure, even in a higher ordered state, as indicated by the LEED pattern and the corresponding B1s- and N1s-XPS signals at 190.4 ev and 398.2 eV, while the O1s- XPS signal has completely vanished beyond the detection limit (Fig. 17 ,5th row). The presented experiment clearly proves that mobile B-N-O-H-species are responsible for the sp2-type BN- layer buildup and oxygen compounds act as surfactants for the formation of individual boronitrene layers. The XPS and LEED data clearly indicate a reversible formation of boron nitride from boron oxide intermediate by a substrate templated reaction not involving boride species. In Table 1, the analysis of the XPS data is summarized.

**Table 1: Summary of the XPS Data (A1 $_{K\alpha}$, hv = 1487 eV)**

| | *O1s* | *N1s* | *B1s* | **annotations** |
|---|---|---|---|---|
| **neat substrate** | not detectable | not detectable | not detectable | no carbon signal detectable |
| **1st step** 45 L **borazine** | not detectable | N 1s 398.0 eV Int.: 20708 | B 1s 190.2 eV Int.: 19147 | B: N approx. 1 : 1.08 no O- or C- signals detectable |
| **2nd step 55L O2 at 900 K** | 531.2 eV Int.:43275 | not detectable | 191.8 eV Int.: 20450 | B1s: one signal B:O ratio approx. 1:2 |
| **3rd step 91 L $NH_3$ at 900 K** | 532.4 eV Int.: 22725 | 398.4 eV Int.: 6875 | 192.8 eV; 190.6 eV Int.: 19161 | B 1s: 2 signals, boron enriched O: Auger signal detectable at > 970 eV |
| **4th step 182 $LNH_3$ at 900K** | 531.6 eV Int.: 12400 | 398.2 eV Int.: 12460 | 192.4 eV, 190.8 eV Int.: 14700 | B 1s: 2 signals O: Auger signal detectable at > 970 eV |
| **5th step 15 h annealing at 900 K** | not detectable | N 1s 398.2 eV Int.: 12167 | B 1s 190.4 eV Int.: 12121 | B 1s: 1 signal, O: NO Auger signal detectable B : N ratio approx. 1:1.01 |
| ***boronitrene* [33]** | - | 398.4 eV | 190.6 eV, | |
| **$B_2O_3$ [30]** | 531.7 | | 192.4 | |
| *) intensities are given in arbitrary units and represent the relative atomic amount | | | | |

**Example 2**

**Formation of highly ordered *boronitrene* layers starting from boric acid derivatives**

*Experimental Setup*

The experiments were performed with the same setup as in Example 1. Fig. 1 b) shows the hexagonal (111) surface of the Rh lattice with the $[\overline{1}\overline{1}2]$ and $[11\overline{2}]$ directions in real space referring to the symmetry axis of the first order spots in reciprocal space. Fig. 1 c) shows the molecular structure of the trimethylborate precursor, $B(OCH_3)_3$.

*Preparation of the boronitrene films*

For the preparation of the BN films, the initial step started with a deposition of trimethylborate $B(OMe)_3$ (with Me = $CH_3$) which was previously cleaned by several cycles of liquid nitrogen freezing and subsequent evacuation of the glass tube down to $1\cdot 10^{-5}$ mbar. For the deposition, the glass tube as well as all the gas lines in contact with the precursor were kept at about 330 K. $B(OMe)_3$, was let into the preparation chamber via a gas inlet, with the nozzle placed immediately above the surface of the substrate. During the deposition, the temperature of the Rh-YSZ-Si(111) multilayer substrate was set to 800 K and the pressure within the preparation chamber was $4.4\cdot 10^{-7}$ mbar for about 450 s, resulting in a nominal deposition of 150 L.

For each step of oxidation, the sample was annealed at 900 K in an oxygen atmosphere of about $4.4\cdot 10^{-7}$ mbar for about 75-150 sec, resulting in nominal doses of 25-50 $LO_2$.

For nitration, the temperature of the sample was also set to 900 K, but due to different reaction kinetics, the $NH_3$ pressure (the deposition time) had to be decreased (increased) by one order of magnitude to about $4.4\cdot 10^{-8}$ mbar (1500 sec.) to keep the same nominal dose of about 50 L $NH_3$ for each step of nitration.

***CVD of trimethylborate $B(OMe)_3$ and formation of a rhodium boride film***

From the study described as Example 1 regarding the chemical stability of boronitrene films, a boron nitride formation from a boron oxide film obtained by oxidation of a BN monolayer was demonstrated by reaction with ammonia. To avoid the use of borazine as a difficult to prepare and handle BN source, alternative routes are of high interest. Taking into account the physical properties and bond stabilities of B-O compounds, trimethylborate was selected as a precursor for B-O- films. It is advantageous to remove potential carbon impurities by oxidation before nitrification of the B-O- film

with ammonia.

Therefore, the decay of trimethylborate was studied in detail. After *in-situ* cleaning of the Rh-YSZ-Si(111) surface ($Ar^+$ ion etching, annealing in 10 L $0_2$ at 900 K) the XPS data in Figure 2 display no detectable O-1s intensity with only very small traces of C-1s from unavoidable adsorbates. This necessary substrate precondition condition is necessary to investigate the neat CVD decay of the precursor.

The deposition of the $B(OMe)_3$ precursor (150 L $B(OMe)_3$ at 800 K) then results in a distinct B-1s signal at 188.4 eV which is close to the value reported for boron segregation in a Rh foil (B-Rh 187.8 eV, J. Kiss et al., Appl. Surf. Sci. 37, 95 (1989)).

Strikingly, no oxygen deposition was detectable throughout the deposition process.

Furthermore, no significant carbon accumulation was detected throughout the reaction sequence displayed in Fig. 4 and Fig. 9.

The findings are only in accordance with a decay of trimethylborate as defined in claim 26 leading to decomposition products acting as a mere boron source for the formation of rhodium boride and volatile species removing the oxygen and carbon present in the precursor.

Thus, the most feasible interpretation of these striking results is a reversed hydroboration process leading to intermediate boron hydrides and the corresponding carbonyl species (the reverse reaction is a very commonly applied reduction of keto compounds with hydrides). The observed reaction occurs at elevated temperatures with a potential catalytic effect of the transition metal substrate.

The boranes can act as a boron source for boron films or borides by reaction with the substrate as observed here: Boron or boride formation:

$$B_2H_6 \rightarrow 3H_2 + 2"B"$$

Therefore, the observed decomposition of the precursor may be used to generate boride films and intermetallic borides on the substrate leading to modified substrate properties (surface hardening) and offer access to $TM_xB_yN_z$ ($C_a$)-films of various composition (TM = transition metal). This type of decomposition of the precursor is an interesting result for material science, because it also offers an easy access to boride coatings for wear resistant materials.

Taking the B-1s intensity as a reference, the shaded areas in Figure 2 represent the O-1s and C-1s intensities that are expected if the full C:O:B = 3:3:1 stoichiometry of the precursor would be displayed in the data. Surprisingly, the O-1s intensity still remains below the detection limit and only a small increase of the C-1s intensity is observed. Although the experimental C:B ratio is in the range of ~ 1:1, there is strong evidence that a complete decomposition of the precursor takes place. For oxygen this is obvious from the lack of any signal. With respect to carbon, we refer to the following argument: According to the XPD data discussed below, the boron is embedded in the Rh lattice, and according to the increase of B-1s intensity during oxidation (cf. next section), only ~ 20% of the overall amount of boron is displayed by the data in Figure 2. Therefore, the experimental C:B = 1:1 ratio rescales to C:B = 0.2: 1, i.e. even if the total amount of C-1s in Figure 2 would result from the precursor, the total amount of carbon is only 6-7% of that in the precursor (C: B = 0.2:1 as rescaled experimental ratio vs. C:B=3:1 from stoichiometry of the precursor).

Fig. 3 shows the XPD data for Rh-3d and B-1s within the [$\overline{1}\overline{1}2$] - [111] - [$11\overline{2}$] symmetry plane. For the clean Rh-YSZ-Si(111) crystal, the intensity distribution of the Rh-3d electrons exhibits all angular features that can be assigned to the main forward-scattering directions of the fee lattice. After the deposition of the precursor, also the B-1s intensity shows an angular anisotropy, but compared to the distinct structures of the Rh-3d scattering, the B-1s intensity just provides a more diffuse scattering pattern with a distinct left-right asymmetry of the [$\overline{1}\overline{1}2$] - [111] and [111] - [$11\overline{2}$] sectors, respectively. Since after deposition, the Rh-3d scattering is nearly the same as for the clean sample, except a slight attenuation of the overall Rh-3d intensity (not shown), a distribution of dilute boron within the Rh lattice has to be expected and therefore, B-B scattering can be neglected within a first approximation. According to the distinct asymmetry in the B-1s XPD pattern, it can be assumed that the boron atoms are rather located at the tetrahedral intersticials of the Rh lattice than at the octahedral sites. In Fig. 3D, a section of the Rh [$\overline{1}\overline{1}2$] - [111] - [$11\overline{2}$] plane is shown with dilute boron occupying both the tetrahedral as well as the octahedral sites. Regarding the next-neighbor B-Rh forward scattering, the tetrahedral sites would rather contribute to intensity maxima within the [111] - [$11\overline{2}$] sector, while in the [$\overline{1}\overline{1}2$] - [111] sector only octahedral sites would contribute to the maxima. Since there is nearly no intensity modulation of B-1s intensity in the [$\overline{1}\overline{1}2$] - [111] sector, the occupation of the octahedral sites is expected to be strongly suppressed.

***Oxidation of the B-Rh surface, formation of boron oxygen compound layer***

According to the results of the previous section, the deposition of 150 L $B(OMe)_3$ at 800 K results in a dilute distribution of single boron atoms within the Rh lattice. In order to induce an anisotropic segregation of the boron atoms that is directed towards the surface, the sample was heated to 900 K and oxidized stepwise by applying doses of 25-50 L $0_2$ for each particular step of oxidation. Fig. 4 shows the C-1s, O-1s and B-1s spectra (with the spectra at 0 L representing

the data from Figure 2) which change considerably, even after applying the first dose of 25 L $0_2$. The C-1s intensity in Fig. 4 a) drops below the detection limit, which gives evidence that the C-1s intensity in Figure 2 just results from surface contaminations. The O-1s intensity in Fig. 4 b) shows a systematic increase and a second contribution appears in the B-1s spectrum in Fig. 4 c) at ~193 eV that can be assigned to the formation to a boron oxide species. Additionally, the presence of oxygen shifts B-1s intensity of the initial B-Rh species from 188.4 eV to 189.2 eV.

With increasing oxygen dose, no intensity is observed in the C-1s spectra in Fig. 4 a) while the O-1s intensity in Fig. 4 b) increases monotonically. In Fig. 4 c), the B-1s contribution at higher binding energy (boron oxide species) also increases monotonically while the B-1s contribution at lower binding energy (B-Rh species) initially remains constant before it starts to drop and finally vanishes. Comparing the B-1s intensities of the initial surface (only B-Rh species) and after full oxidation at about 925 L $0_2$ (only boron oxide species) there is an overall increase of boron intensity by about 500% during oxidation, although no additional boron was provided. Therefore, the overall amount of boron, as deposited by applying 150 L $B(OMe)_3$ in the previous section, is distributed deep within the Rh lattice and due the high surface sensitivity of the technique, only a small fraction of boron is seen in Figure 2 after the deposition of the precursor. Since there is no C-1s intensity even after the first dose of oxygen, a bulk-like distribution of carbon can be excluded, i.e., in contrast to the B-1s intensity in Fig. 2, which displays only 20 % of the overall boron amount, the C-1s intensity in Figure 2 displays the full amount of carbon present on the substrate, resulting in the C:B=0.2:1 ratio discussed in the previous section.

For a quantitative analysis, the intensities from Fig. 4 are compared in Fig. 5. In Fig. 5 a), the B-1s intensity from the oxide species runs nearly parallel to the O-1s intensity, and the ratio of both curves in Fig. 5 b) predicts the formation of a boron oxide species with B:0 = 1:2 ratio after full oxidation. The B-1s intensity from the Rh-B species in Fig. 5 a) starts with a constant value and finally drops to zero, indicating that the portion of boron that is transformed from the Rh-B species into boron oxide is first replaced by a diffusion of boron from the bulk to the surface. If this source of boron starts to get exhausted, the formation of boron oxide finally causes the Rh-B species to vanish.

For the boron oxide species in Fig. 4 c), the observed binding energy of about 193 eV is characteristic for ortho boric acid (D.N. Hendrickson et al., Inorg. Chem. 9, 612 (1969), J.A. Schreifels et al., J. Catal. 65, 195 (1980)) with a B: O = 1:3 ratio, as depicted in Fig. 6 a). This ratio deviates from the experimental B:0 = 1:2 ratio in Fig. 5 b), and therefore, we assume the formation of metaboric acid which provides the observed B:O = 1:2 ratio (M. Elango et al., J. Phys. Chem. A 112, 8107 (2008), as depicted in Fig. 6 b). Since the chemical coordination of boron is similar for both compounds (boron within an oxygen triangle) the observed binding energy is expected to be also characteristic for metaboric acid.

For an estimation of the thickness of the boron oxide layer, the attenuation of the photoelectron intensity from Rh is compared for the clean and the oxide covered surface. In order to reduce angular intensity modulations by forward scattering, the intensity of the Rh MVV-Auger electrons with low kinetic energies (~ 300 eV for Al-$K_\alpha$ radiation) was recorded for full angular apertures. Since the XPD patterns in Fig. 7 still display distinct intensity modulations by forward scattering, the data were azimuthally averaged. For an oxide layer of thickness d, the polar intensity distribution of the clean surface $\langle I_0(\vartheta)\rangle$ is then attenuated by

$$\left\langle I(\vartheta)\right\rangle = \left\langle I_0(\vartheta)\right\rangle \cdot \exp\left(-\frac{d}{\lambda \cdot \cos\vartheta}\right)$$

for a particular polar angle $\vartheta$. Here, the < ... > describes the azimuthal average and $\lambda$ represents the mean free path of the electrons, ($\lambda$~1 nm) according to the so-called "universal curve" (M.P. Seah et al., Surf. Interface Anal. 1, 2 (1979)). The ratio of the polar intensity distribution for the clean and oxide covered surface results in a mean film thickness of

$$d_{oxide} = 0.8 \cdot \lambda \sim 8\ \text{Å}$$

In contrast to the crystalline order of the Rh surface, as displayed by the XPD pattern of the Rh-MVV-Auger electrons in Fig. 8 a), no ordering can be observed for the oxide film. The corresponding XPD patterns for O-1s and B-1s in Fig. 8 b)-c) do not exhibit any intensity modulations, indicating the formation of a glass-like boron oxide layer, as, e.g., by metaboric acid.

***Nitrification of the boron oxygen compound layer, formation of boronitrene***

In the last step of preparation, the boron oxide film can be transformed to boronitrene by successive nitrification within a $NH_3$ atmosphere at 900 K. Compared to the oxidation of the previous section, nitrification seems to be driven by much slower reaction kinetics. The best results were obtained by increasing/decreasing the reaction time/pressure by at least one order of magnitude compared to the settings in the oxidation process to have the same dosage for each step of preparation (oxidation at $4.4 \cdot 10^{-7}$ mbar $O_2$ for 150 sec. vs. $4.4 \cdot 10^{-8}$ mbar $NH_3$ for 1500 sec. for 50 L). Following this procedure, it is possible to transform the disordered oxide layer completely into a well-ordered boronitrene layer.

Fig. 9 shows the C-1s, O-1s, N-Is and B-1s spectra by applying $NH_3$ in doses of 50 L, with the spectra at 0 L $NH_3$ representing the spectra for full oxidation at 925 L $O_2$ from Fig. 4. Similar to oxidation, the C-1s intensity in Fig. 9 a) is at the detection limit throughout the whole series. With increasing $NH_3$ dose, the initial O-1s intensity in Fig. 9 b) finally drops to zero, while in Fig. 9 c), an N-1s peak increases to saturation at the BN-like energy of 398.2 eV (F: Müller et al., Surf. Sci. 602 (2008) 3467-3476). The behavior of the B-1s intensity in Fig. 9 d) is similar as in the oxidation series, i.e., a second peaks appears, but now, the intensity is shifted from higher binding energy to lower binding energy at ~ 190.6 eV due to the formation of boronitrene (M. Romand et al., Analysis 4 (1976), 308, F. Müller et al., Surf. Sci. 602 (2008) 3467-3476). In contrast to oxidation, the overall B-1s intensity slightly decreases, probably by the formation of volatile boron species during the boron oxide - BN transformation. In addition to the observed BN-like binding energies for N-1s and B-1s, as observed in Fig. 9 c)-d), the formation of BN is also confirmed by the quantitative analysis of both intensities. In Fig. 10, the normalized B-1s and N-1s intensities approach to a common value and as soon as the O-1s intensity disappears, the B:N ratio is close to unity.

If the thickness of the BN coverage is estimated in the same way as the thickness of the boron oxide layer in the previous section, the attenuation of the Rh intensity in Fig. 11 results in a thickness of about

$$d_{BN} = 0.2 \cdot \lambda \sim 2\ Å$$

Taking the interlayer spacing of BN along the c-axis as a reference (~ 3 Å), this thickness corresponds to a nominal coverage by about 2/3 monolayers of boronitrene.

**Surface structures**

For a qualitative interpretation of the surface structures Fig. 12 compares the LEED patterns in the range of the first order spots. For the clean Rh(111) surface, Fig. 12 a) provides a sharp LEED pattern with a six-fold arrangement of distinct spots with threefold intensity distribution, indicating that the clean surface represents an array of large, well-ordered domains with uniform orientation. After the deposition of the $B(OMe)_3$ precursor, the LEED pattern is nearly the same (not shown), except a slightly reduced peak-to-background ratio due to the dilute distribution of boron within the intersticials of the Rh lattice, as discussed in the section concerning the formation of the initial rhodium boride layer. After oxidation, the LEED pattern in Fig. 12 b) displays a diffuse intensity distribution due to the formation of a disordered boron oxide layer of 8 Å thickness, as discussed before. After nitration of the boron oxide layer, the formation of 2/3 monolayer of boronitrene then results in an increased peak-to-background ratio in Fig. 12 c), indicating that the disordered oxide film is transformed into a well-ordered boronitrene layer. Compared to the clean Rh(111) surface in Fig. 12 a), the principal spots from the Rh lattice are now surrounded by a 6-fold arrangement of additional intensity, as indicated in Fig. 12 d). These spots result from the boronitrene/Rh(111) coincidence lattice and display the formation of the boronitrene NanoMesh (see F. Müller et al., Surf. Sci. 603, 425 (2009) and references therein).

For a quantitative analysis, the polar intensity distributions along the $[\overline{1}\overline{1}2]$ axis (as indicated by the grey area in Fig. 12 a)), are compared in Fig. 13. The high degree of order for the clean Rh(111) surface and the boronitrene/Rh (111) superstructure is displayed by the nearly vanishing background intensity in Fig. 13 a). In contrast, the disordered boron oxide layer strongly suppresses the substrate spots, and the LEED profiles is dominated by a large background intensity. Since the lattice mismatch of the boronitrene and the Rh(111) lattice determines the size of the superstructure via the (n+1 x n+1)/(nxn) coincidence lattice, the spacing of the non-integral superstructure spots are distributed in fraction of 1/n in k-space if the (00) and (10) spots of the substrate are set to $\Delta q^{II} = 0$ and $\Delta q^{II} = 1$, respectively. Fig. 13b)-c) show the LEED profiles of the (00) spot and the (10) spot along $[\overline{1}\overline{1}2]$ direction with the red lines representing the peak positions for n = 12 and the blue lines representing the peak positions for n = 13. Fig. 13 b)-c) give evidence that the superstructure spots are distributed rather in fractions of 1/13 than in fractions of 1/12, i.e. for the Rh-YSZ-Si (111) multilayer substrate used here, the size of the boronitrene superstructure is increased by one unit cell compared to a Rh(111) single crystal surface (M. Corso, Science 303, 217 (2004)). This phenomenon, as recently also observed for the growth of boronitrene on Rh-YSZ-Si(111) by using a borazine precursor, can be attributed to the different thermal

properties of the Rh-YSZ-Si(111) multilayer system (F. Müller et al., Surf. Sci. 603, 425 (2009)). However, it has to be stated, that the observation of a (14x14)/(13x13) superstructure is not a unique result. Throughout the preparation of a large variety of boronitrene/Rh-YSZ-Si(111) layers, the size of the superstructure can vary between (14x14)/(13x13) or a mixture of (14x14)/(13x13) and (13x13)/(12x12), i.e. the distribution of the superstructure spots is non-equidistant in the latter case, even if the parameters of preparation are fixed within the experimental error bars. However, apart from the size of the superstructure the LEED data from Figs. 12 and 13 give clear evidence that the three-step boration-oxidation-nitration process finally results in the formation of a well-ordered boronitrene layer.

The formation of boronitrene on epitaxial Rh(111) by the inventive process is summarized in Fig. 14. Of course, the mechanism is expected to work also for a Rh(111) single crystal surface, but since the major motivation of the present study aims at the wafer-size mass production of boronitrene layers, the experiments were just performed by using Si-based Rh-YSZ-Si(111) substrates as the low-cost Rh(111) counterpart.

**Formation of boronitrene by a two-step boration-nitration process**

The growth of boronitrene monolayers, according to the invention, can also be obtained by an analogue less preferred two-step boration-nitration process without an intermediate oxidation of the initial B-Rh compound. The deposition/decomposition of the $B(OMe)_3$ precursor and the nitration of the resulting B-Rh surfaces were similar to the procedures described above. Fig. 15 shows the spectral series of the C-1s, O-1s, N-1s and B-1s intensities for successive nitration of the B-Rh compound by $NH_3$ at 900 K. Similar to the boration-oxidation-nitration process, the B-1s spectra in Fig. 15 d) exhibit an additional contribution that can be assigned to the formation of BN, but in contrast to the three-step process, it is not possible to transform the B-1s intensity from the B-Rh species completely into B-1s intensity from BN. With increasing $NH_3$ dosage, both B-1s intensities finally display a constant intensity ratio. By comparing the BN related B-1s intensity at about 190.6 eV and the N-1s intensity, the intensity ratio is in the range of B:N ~0.9:1, i.e., even without an intermediate oxidation, it is possible to transform a portion of boron from the B-Rh compound into BN just by applying $NH_3$. However, without intermediate oxidation, it seems to be not possible to extract all of the boron atoms out of the Rh intersticials just by applying $NH_3$. For the two-step process, the C-1s intensities are much higher than for the three-step process, since initial carbon impurities cannot be eliminated by the intermediate oxidation.

With respect to the surface structure, the portion of boron nitride that is formed during nitration exhibits a lower degree of order, compared to the boronitrene layer that is formed by the three-step process. The LEED profile in Fig. 16 b) displays an additional intensity for the (10) spot at higher transfer of momentum, but this intensity just appears as a diffuse structure. In contrast to the LEED profiles of the boronitrene film from the three-step process in Fig. 13 b)-c), no additional spots due to the formation of a superstructure can be observed in Fig. 16. Therefore, it can be expected, that for the two-step process the average domain size is smaller than the periodicity of the boronitrene /Rh coincidence lattice, which is in the range of about 3.2 nm.

In general, it is possible to prepare boronitrene even by a two-step boration-nitration process, but this kind of preparation suffers from two deficiencies: First, it is not possible to transform all boron from the B-Rh species into BN-like species, secondly, the structural quality of the "boronitrene" film is not as high as that of the three-step process. But it is possible to improve the quality of the boronitrene layers for the two-step process by optimizing the parameters of preparation, such as temperature, pressure or deposition time.

**Claims**

1. Process for forming thin layers of metal nitrides MN, wherein M is an element selected from the group consisting of B, Al, Si, Ge, Sn Ti, Zr, Hf, the lanthanides, the actinides and the transition metals, on a surface, comprising the steps

    (a) providing a thin nitride layer by a conventional CVD or PVD method on a substrate,
    (b) oxidation of the nitride layer using oxygen gas,
    (c) nitrification of the oxidized layer using a nitrogen-containing gas,
    (d) optionally annealing by heating.

2. The process of claim 1, wherein the substrate has a surface having a hexagonal or pseudohexagonal structure, in particular a (111) surface of a face-centered cubic lattice or a (0001) surface of a hexagonal lattice.

3. The process of claim 1 or 2 wherein
M is B,
the thin boron nitride layer is provided by CVD of borazine or trichloroborazine, and/or
the substrate has a surface having a hexagonal or pseudohexagonal structure selected from Rh(111), Ru(0001),

Ag(111), Cr(110), Pt(111), Pd(111), Ni(111), Mo(110) either as single crystals or epitaxial layers, and/or the nitrogen containing gas is ammonia.

**4.** The process of claim 2 or 3, wherein M is B, the layer thus is a boronitrene layer layer, and the substrate has a hexagonal surface structure selected from single crystal or epitaxial Rh(111).

**5.** The process of one or more of claims 1 to 4, wherein the thin layer is a monolayer.

**6.** The process of one or more of claims 1 to 5, additionally comprising a step of annealing by heating between step (a) and step (b).

**7.** The process of one or more of claims 1 to 6, additionally comprising a step of annealing by heating after step (c).

**8.** Process for forming thin layers of metal nitrides MN, wherein M is an element selected from the group consisting of B, Al, Si, Ge, Sn Ti, Zr, Hf, the lanthanides, the actinides and the transition metals, on a surface, comprising the steps

a*) wherein a thin nitride layer is provided by CVD of M(OR)X, wherein M is defined as in claim 1, OR is an alcoholate with $\alpha$-CH- functionality which may optionally be substituted by halogen, alkyl or aryl, and x is an integer according to the valency of M,
(b) optionally oxidation of the nitride layer using oxygen gas,
(c) nitrification of the oxidized layer using a nitrogen-containing gas,
(d) optionally annealing by heating.

**9.** Article having a thin layer of MN, obtainable by the process of one or more of claims 1 to 8.

**10.** Use of a thin layer of MN obtained by the process of one or more of claims 1 to 8 in the manufacture of electronic devices.

**11.** Use according to claim 10, wherein the thin layer is a monolayer.

**12.** Use according to claim 10 or 11 wherein the electronic device is a nano-electronic device.

**13.** Process for hardening the surface of a substrate comprising a step (a*) as defined in claim 8.

**14.** Process for forming a thin oxygen compound layer on a substrate, comprising the steps (a*) as defined in claim 13, (b) oxidation of the nitride layer using oxygen gas.

**15.** Process according to claim 14 wherein the oxygen compound layer has a thickness of 0,5 to 5 nm, preferably 0,8 to 1,5 nm, most preferably approx. 1 nm.

**16.** Process according to one or more of claims 15 to 17 wherein the substrate has a hexagonal or pseudohexagonal surface structure, in particular a (111) surface of a face-centered cubic lattice or a (0001) surface of a hexagonal lattice.

**17.** Process according to one or more of claims 13 to 16, wherein M is B and the substrate has a surface selected from single-crystal and epitaxial Rh(111).

**18.** The process according to any of claims 8 or 13 to 16, wherein $M(OR)_x$ is $B(OR)_3$, wherein R is defined as in claim 8.

**19.** The process according to claim 18, wherein $M(OR)_x$ is $B(OMe)_3$.

**20.** Article having a hardened surface layer, obtainable by a process according to one or more of claims 8 and 13 to 16.

**21.** Article having a thin oxygen compound layer, obtainable by a process according to one or more of claims 14 to 19.

**22.** Use of a thin oxygen compound layer obtainable according to one or more of claims 14 to 19, in an electronic device, preferably a nano-electronic device.

**23.** Use according to claim 22 as an insulating buffer.

**24.** Article, comprising an epitaxial Rh(111) substrate and provided thereon, a hardened surface comprising implanted M atoms or a thin oxide layer, wherein M is an element selected from the group consisting of B, Al, Si, Ge, Sn Ti, Zr, Hf, the lanthanides, the actinides and the transition metals, preferably B, Ti, Hf or Zr and more preferably B.

**25.** Use of an epitaxial Rh(111) surface in a process as defined in one or more of claims 8 or 13 to 19.

**26.** Process for obtaining metal hydrides and aldehydes/ketones from alcoholates in the presence of a transition metal surface according to the following reaction scheme

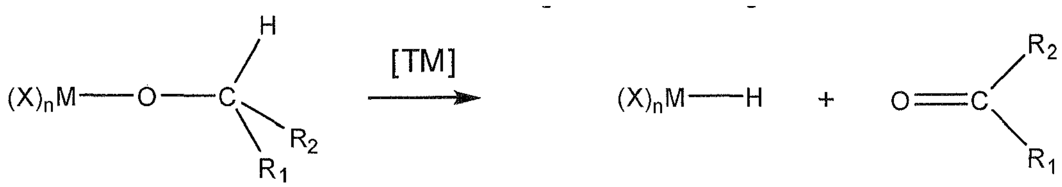


wherein TM is a transition metal selected from the group consisting of Rh, Ru, Ag, Cr, Pt, Pd, Ni, Mo, preferably Rh; M is a metal selected form the group consisting of B, Al, Si, Ge, Sn Ti, Zr, Hf, the lanthanides, the actinides and the transition metals, preferably B, Ti, Hf or Zr and more preferably B; $R_1$ and $R_2$ are the same or different and are selected from the group consisting of aryl, alkyl and hydrogen; X is a substituent selected from halogen, alkyl, aryl, and n is an integer according to the valency of M.

Fig. 1

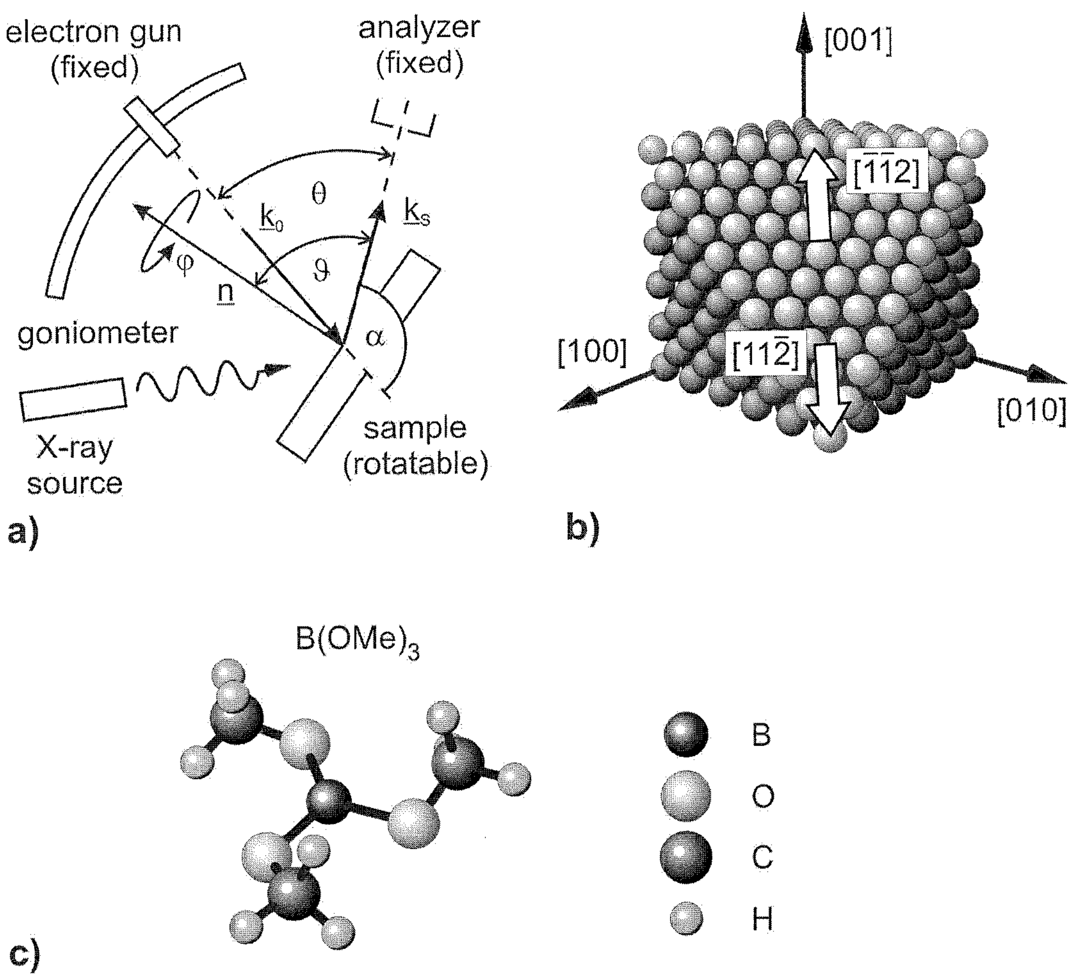
electron gun
(fixed)
analyzer
(fixed)
θ
$\underline{k}_0$
$\underline{k}_s$
φ
ϑ
$\underline{n}$
goniometer
α
X-ray
source
sample
(rotatable)
a)
[001]
[$\bar{1}\bar{1}$2]
[100]
[11$\bar{2}$]
[010]
b)
$B(OMe)_3$
c)

Fig. 2

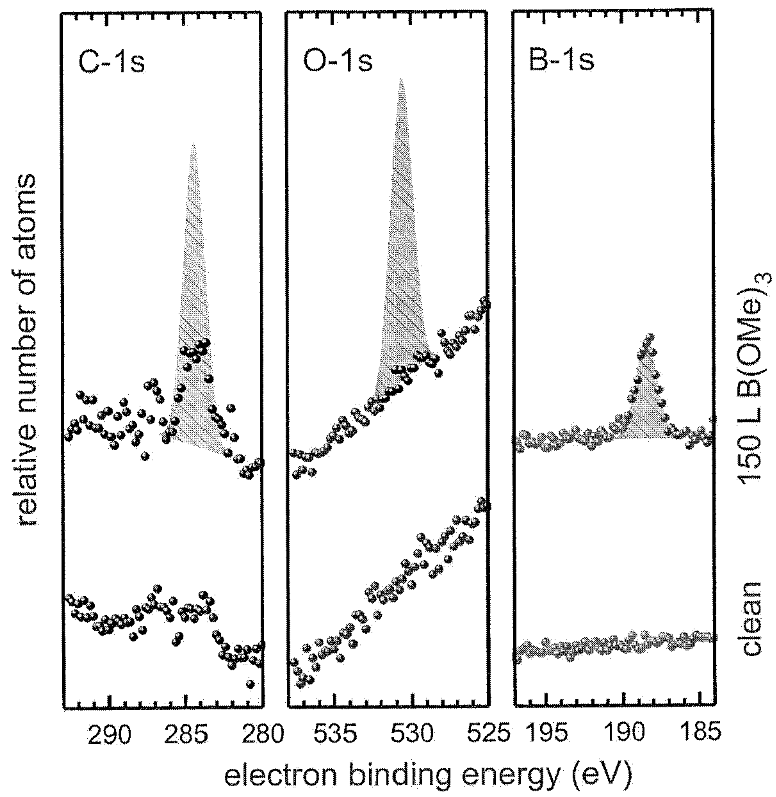
C-1s
O-1s
B-1s
relative number of atoms
150 L B(OMe)3
clean
290 285 280 535 530 525 195 190 185
electron binding energy (eV)

**Fig. 3**

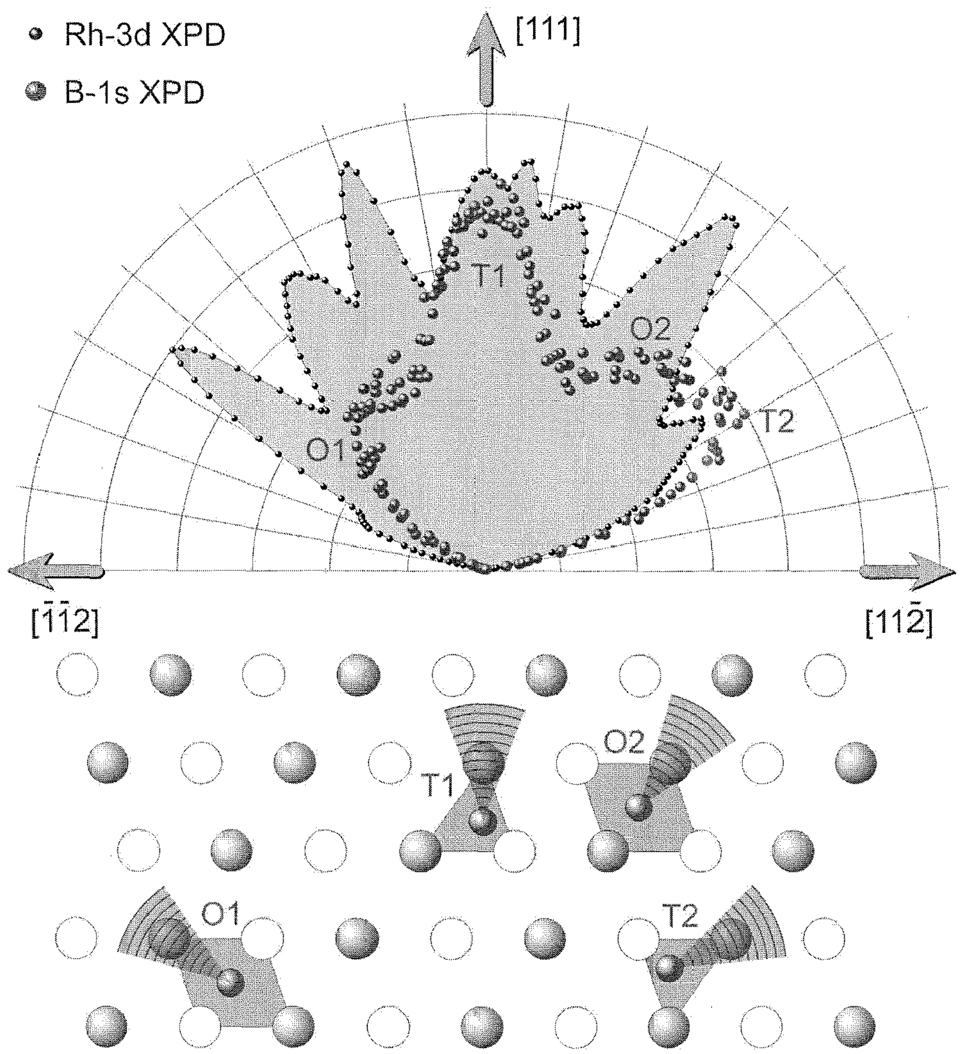

Fig. 4

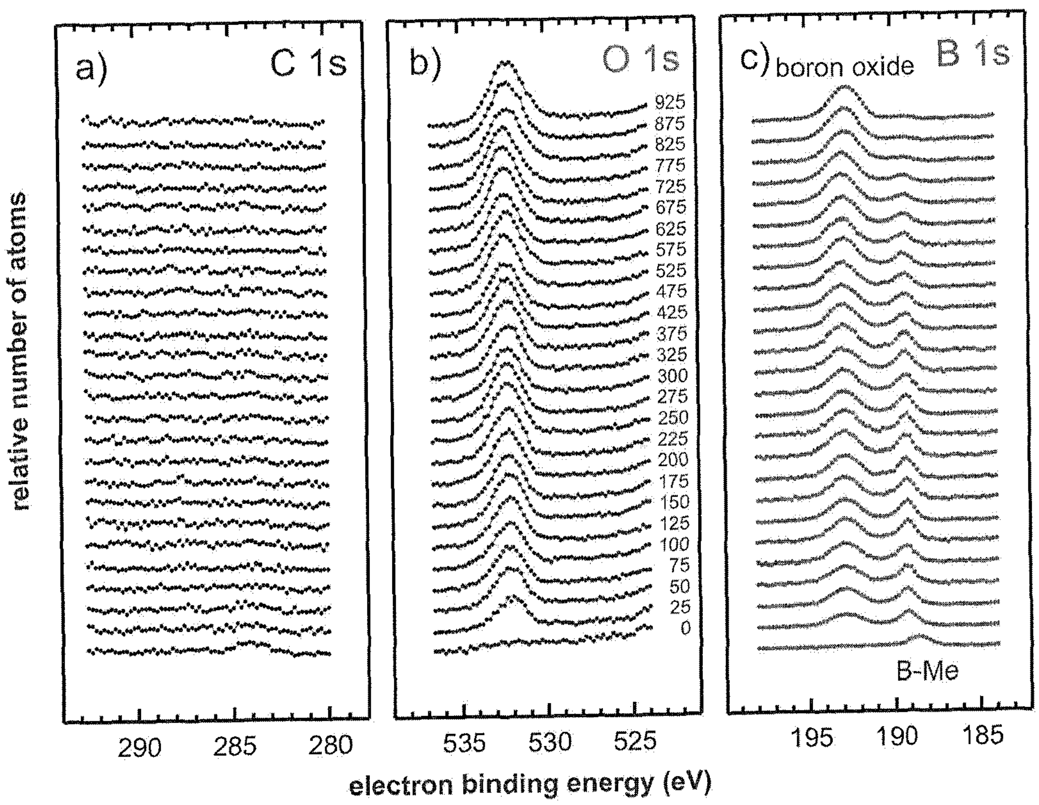
a)
C 1s
b)
O 1s
c) boron oxide
B 1s
925
875
825
775
725
675
625
575
525
475
425
375
325
300
275
250
225
200
175
150
125
100
75
50
25
0
B-Me
relative number of atoms
290
285
280
535
530
525
195
190
185
electron binding energy (eV)

**Fig. 5**

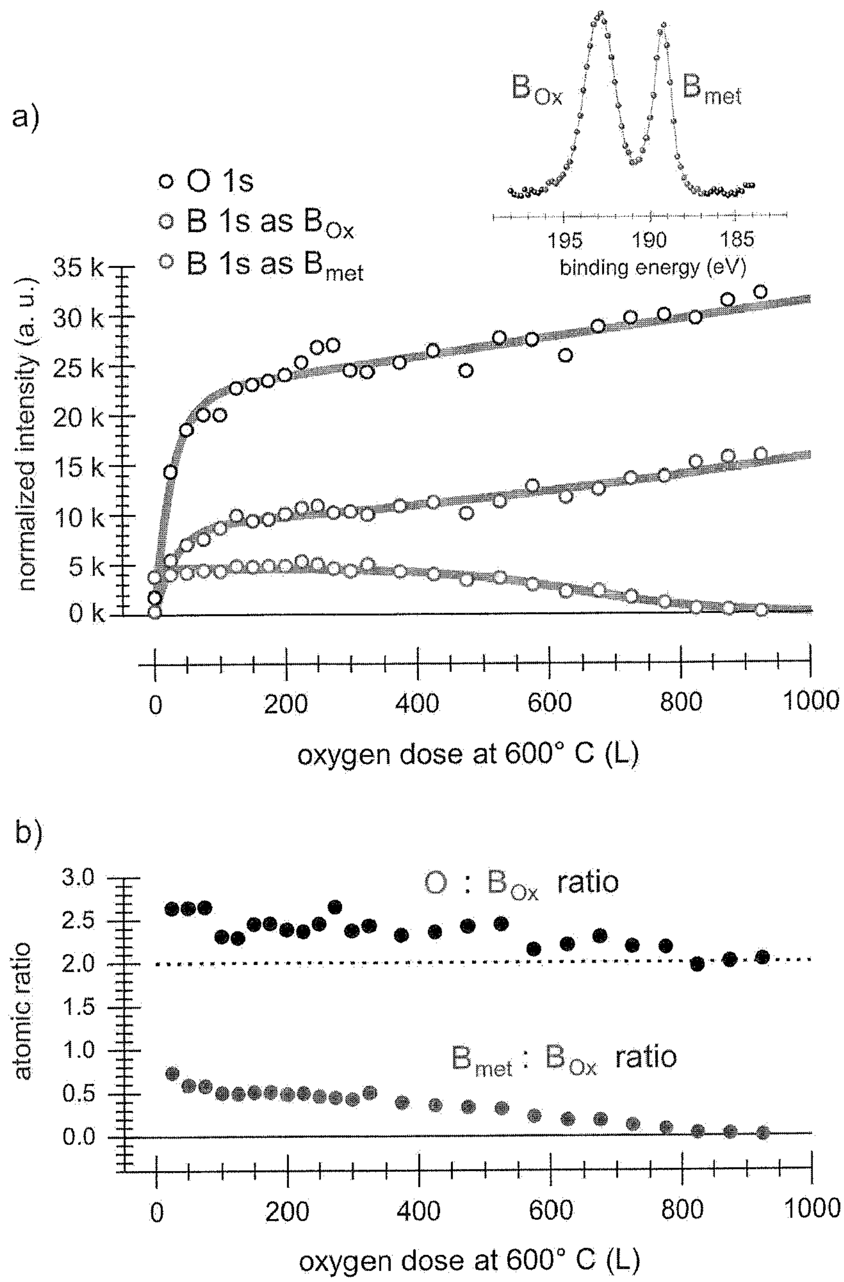
a)
O 1s
B 1s as $B_{Ox}$
B 1s as $B_{met}$
$B_{Ox}$
$B_{met}$
195
190
185
binding energy (eV)
normalized intensity (a. u.)
35 k
30 k
25 k
20 k
15 k
10 k
5 k
0 k
0
200
400
600
800
1000
oxygen dose at 600° C (L)
b)
O : $B_{Ox}$ ratio
$B_{met}$ : $B_{Ox}$ ratio
atomic ratio
3.0
2.5
2.0
1.5
1.0
0.5
0.0
0
200
400
600
800
1000
oxygen dose at 600° C (L)

**Fig. 6**

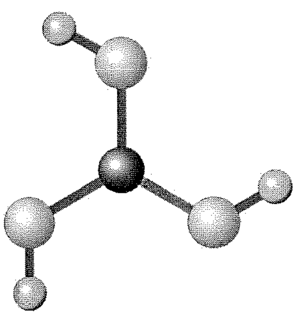

$B(OH)_3$

**a)**

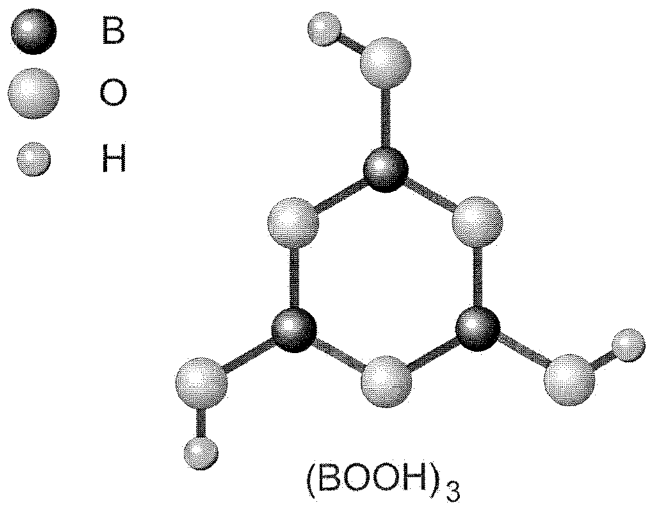

$(BOOH)_3$

**b)**

Fig. 7

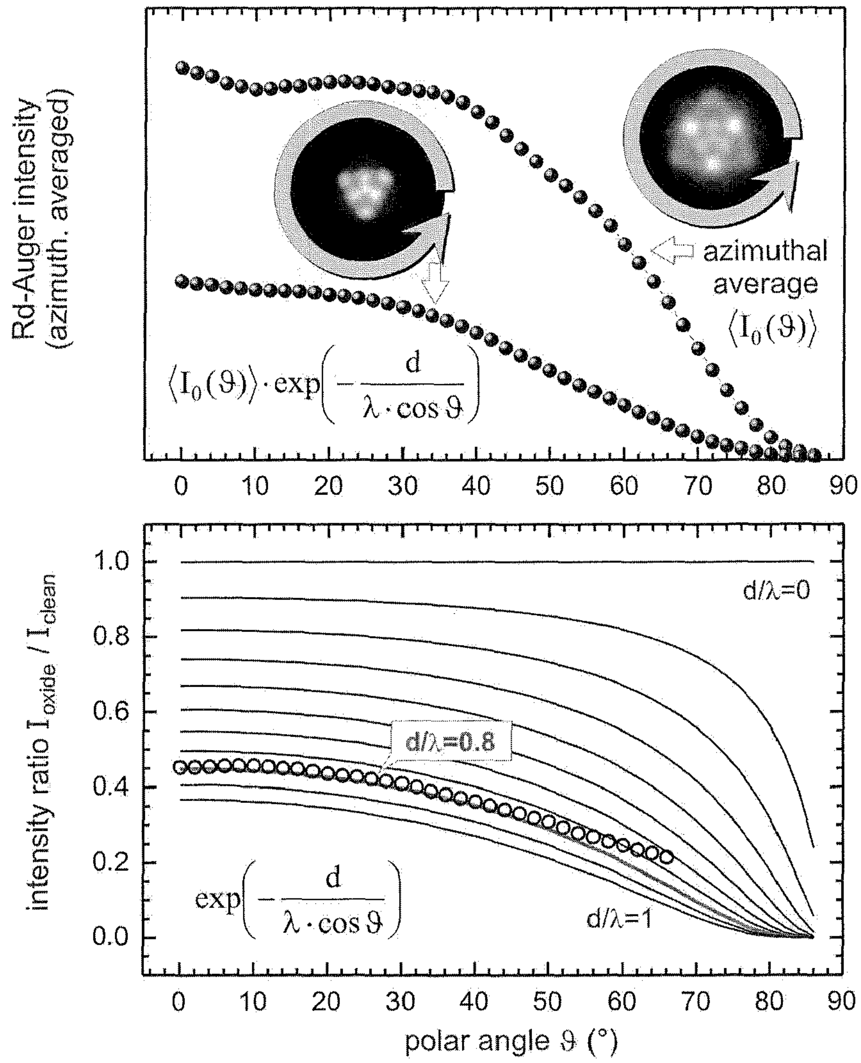
Rd-Auger intensity (azimuth. averaged)
azimuthal average
$\langle I_0(\vartheta)\rangle$
$\langle I_0(\vartheta)\rangle \cdot \exp\left(-\frac{d}{\lambda \cdot \cos\vartheta}\right)$
0 10 20 30 40 50 60 70 80 90
intensity ratio $I_{oxide} / I_{clean}$
1.0 0.8 0.6 0.4 0.2 0.0
d/λ=0
d/λ=0.8
d/λ=1
$\exp\left(-\frac{d}{\lambda \cdot \cos\vartheta}\right)$
0 10 20 30 40 50 60 70 80 90
polar angle ϑ (°)

Fig. 8

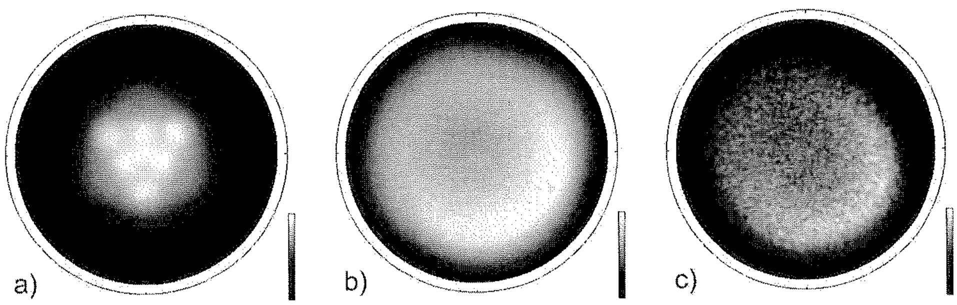

Fig. 9

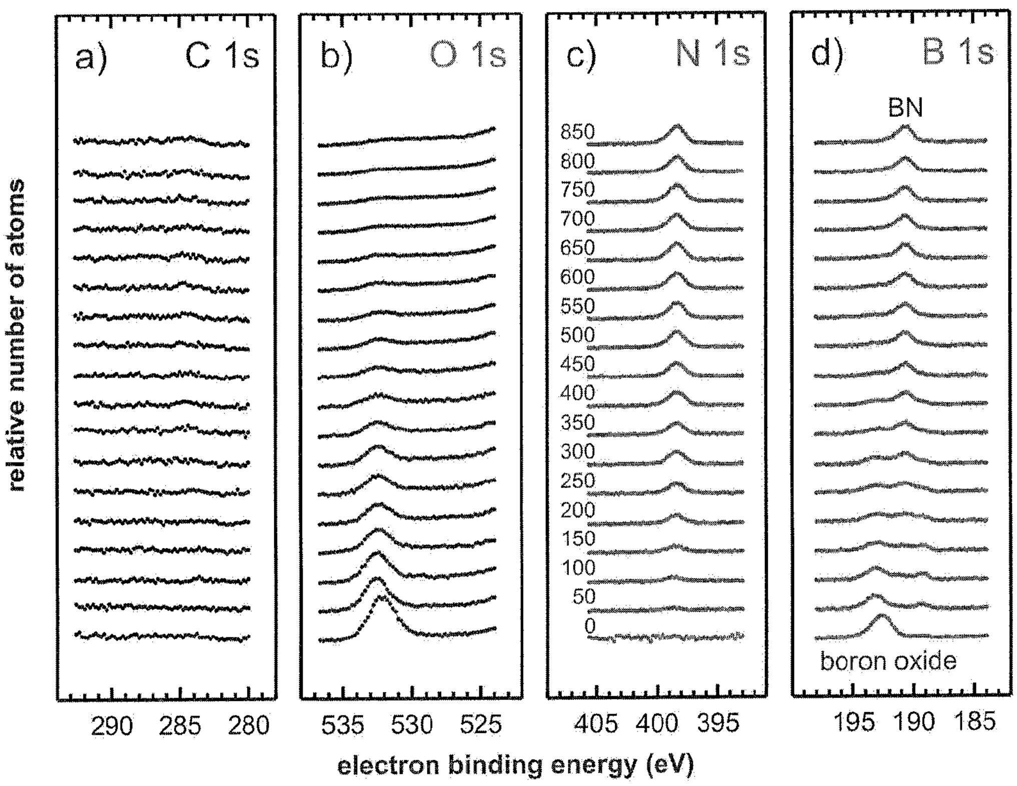
a) C 1s
b) O 1s
c) N 1s
d) B 1s
BN
850
800
750
700
650
600
550
500
450
400
350
300
250
200
150
100
50
0
boron oxide
290 285 280
535 530 525
405 400 395
195 190 185
electron binding energy (eV)
relative number of atoms

Fig. 10

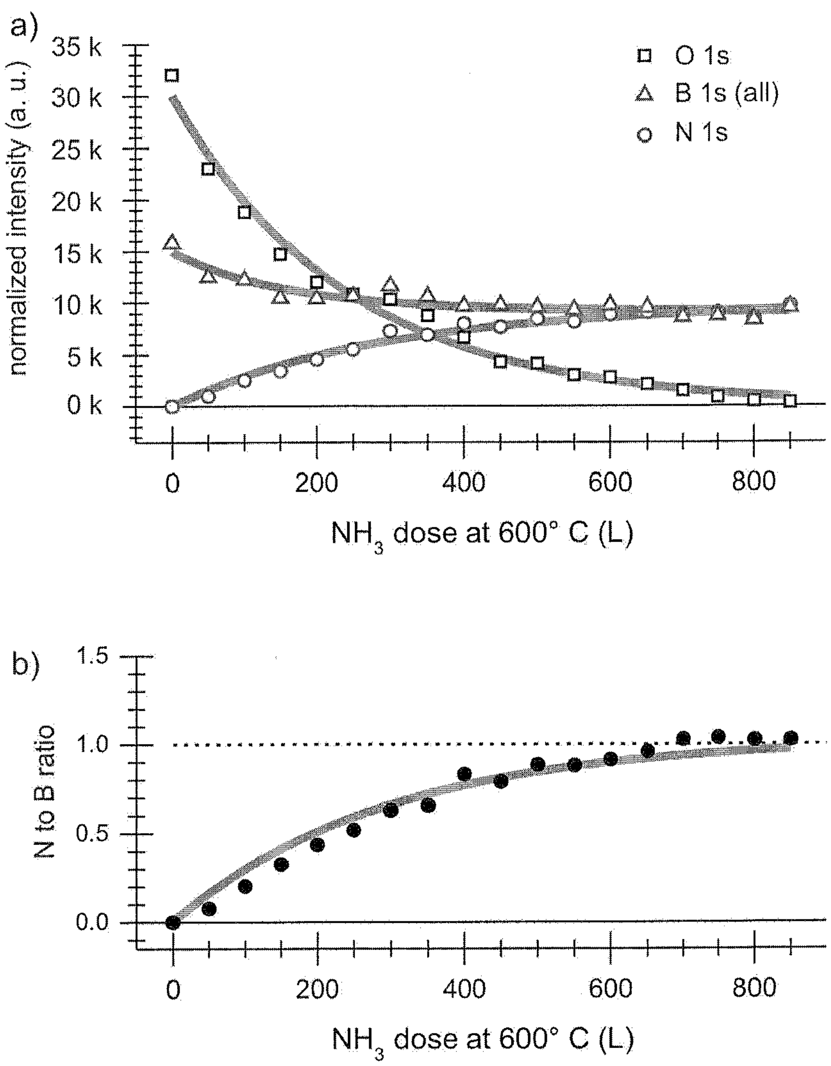
a)
35 k
30 k
25 k
20 k
15 k
10 k
5 k
0 k
normalized intensity (a. u.)
O 1s
B 1s (all)
N 1s
0
200
400
600
800
NH3 dose at 600° C (L)
b)
1.5
1.0
0.5
0.0
N to B ratio
0
200
400
600
800
NH3 dose at 600° C (L)

Fig. 11

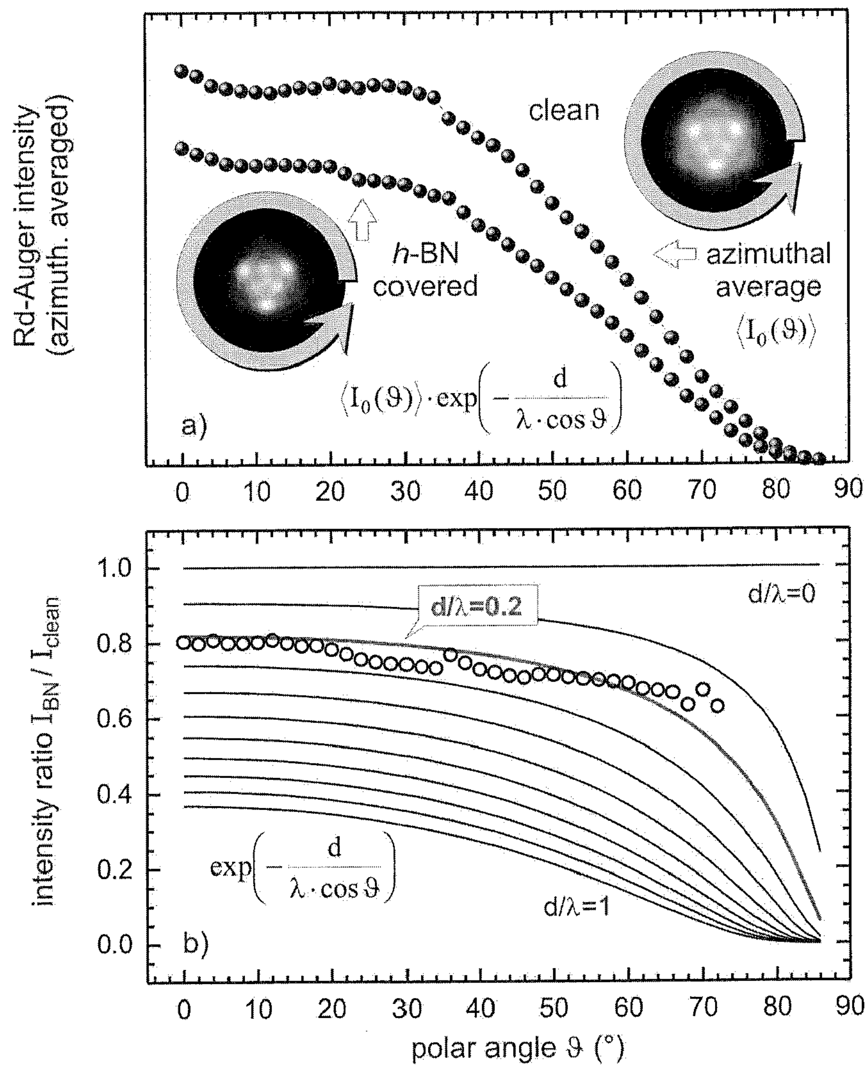
Rd-Auger intensity
(azimuth. averaged)
clean
h-BN
covered
azimuthal
average
$\langle I_0(\vartheta)\rangle$
$\langle I_0(\vartheta)\rangle \cdot \exp\left(-\frac{d}{\lambda \cdot \cos\vartheta}\right)$
a)
0 10 20 30 40 50 60 70 80 90
intensity ratio $I_{BN} / I_{clean}$
1.0
0.8
0.6
0.4
0.2
0.0
d/λ=0.2
d/λ=0
$\exp\left(-\frac{d}{\lambda \cdot \cos\vartheta}\right)$
d/λ=1
b)
0 10 20 30 40 50 60 70 80 90
polar angle ϑ (°)

Fig. 12

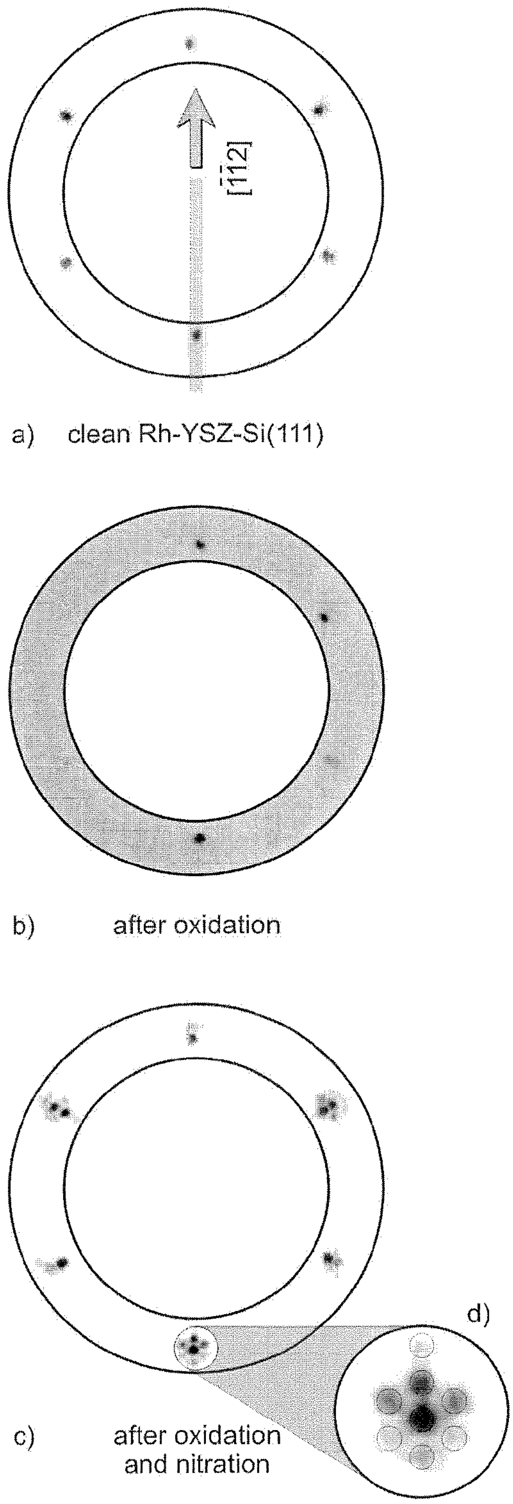
[1̄1̄2]
a) clean Rh-YSZ-Si(111)
b) after oxidation
c) after oxidation and nitration
d)

Fig. 13

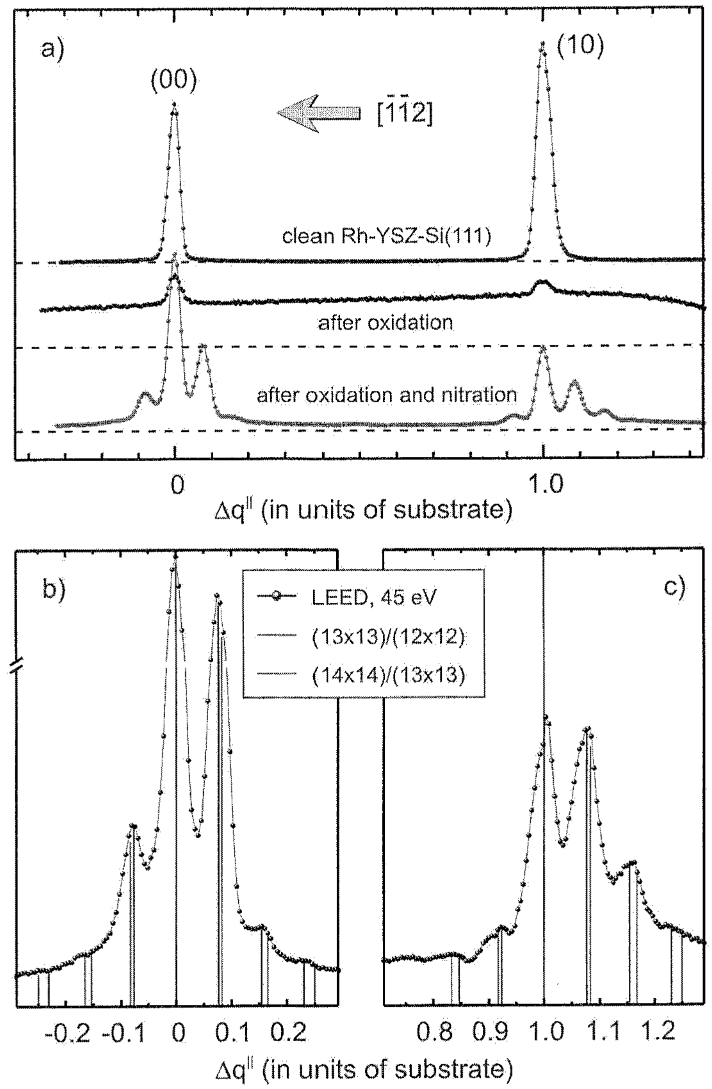
a)
(00)
(10)
[$\bar{1}\bar{1}$2]
clean Rh-YSZ-Si(111)
after oxidation
after oxidation and nitration
0
1.0
Δq^|| (in units of substrate)
b)
c)
LEED, 45 eV
(13x13)/(12x12)
(14x14)/(13x13)
-0.2 -0.1 0 0.1 0.2
0.8 0.9 1.0 1.1 1.2
Δq^|| (in units of substrate)

Fig. 14

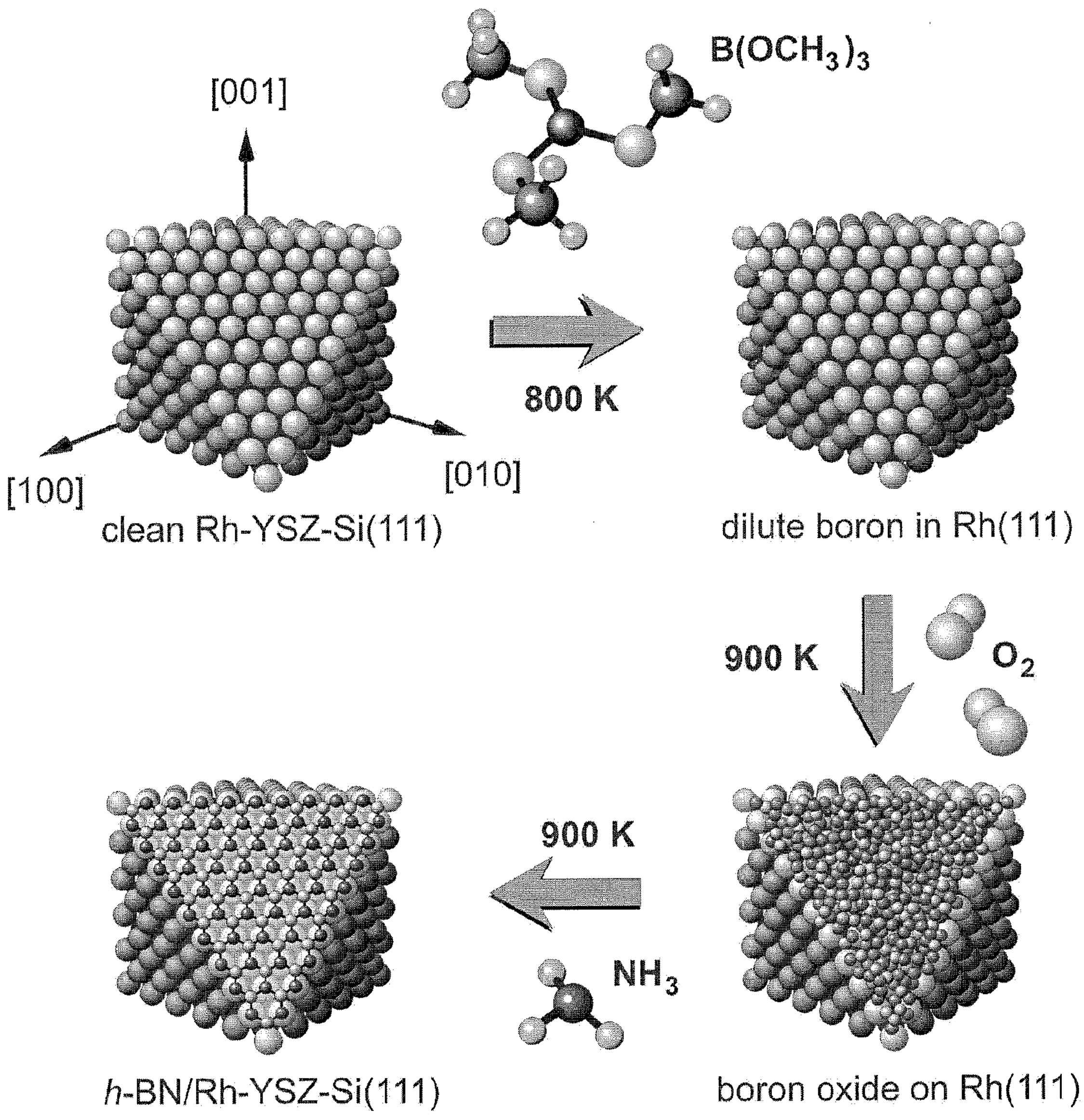

[001]
B(OCH3)3
800 K
[100]
[010]
clean Rh-YSZ-Si(111)
dilute boron in Rh(111)
900 K
O2
900 K
NH3
h-BN/Rh-YSZ-Si(111)
boron oxide on Rh(111)

Fig. 15

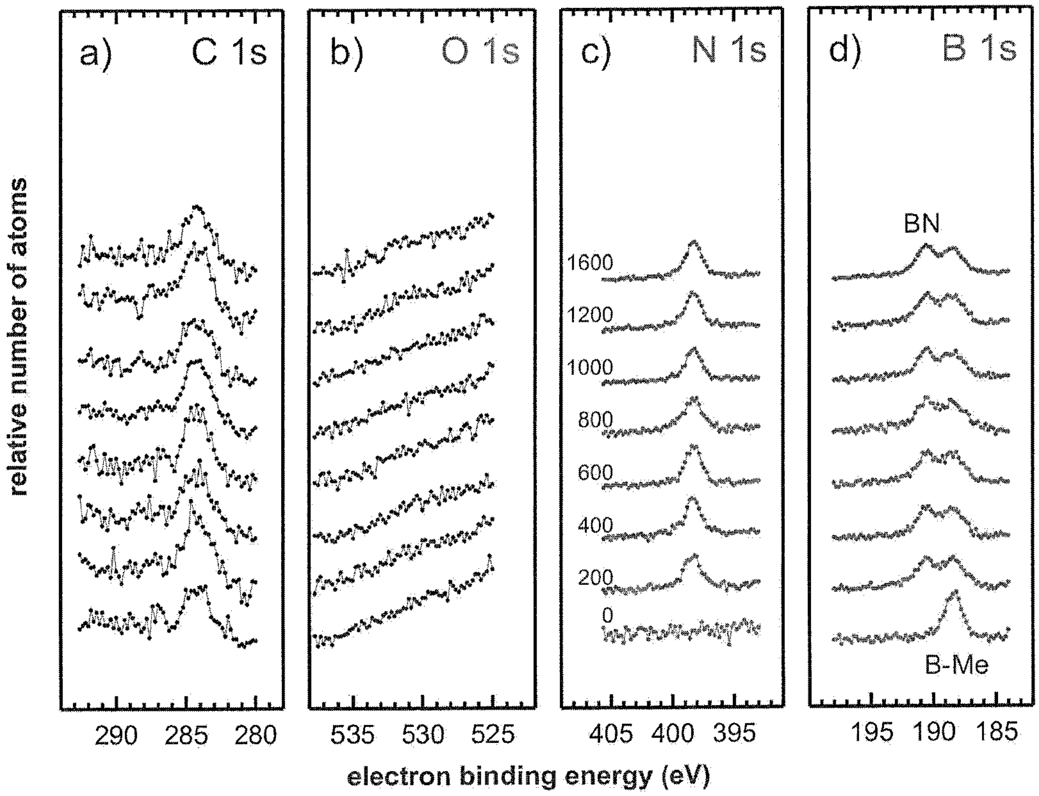
a) C 1s
b) O 1s
c) N 1s
d) B 1s
relative number of atoms
1600
1200
1000
800
600
400
200
0
BN
B-Me
290 285 280
535 530 525
405 400 395
195 190 185
electron binding energy (eV)

Fig. 16

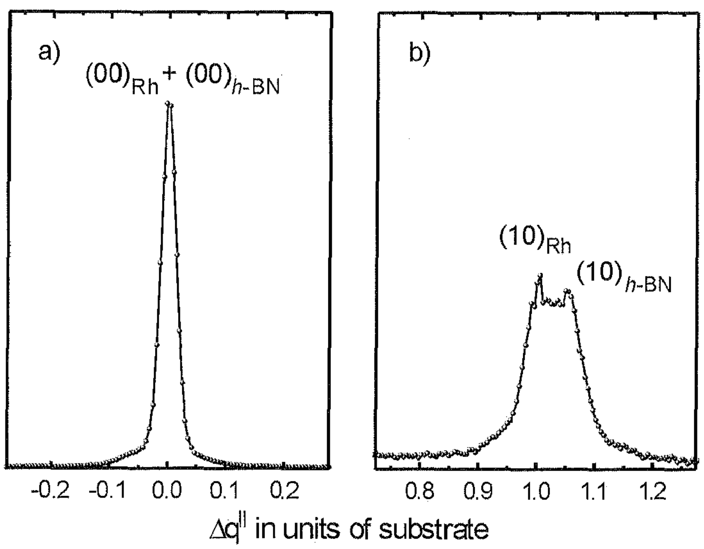
a)
(00)Rh + (00)h-BN
b)
(10)Rh
(10)h-BN
-0.2 -0.1 0.0 0.1 0.2
0.8 0.9 1.0 1.1 1.2
Δq|| in units of substrate

Fig. 17

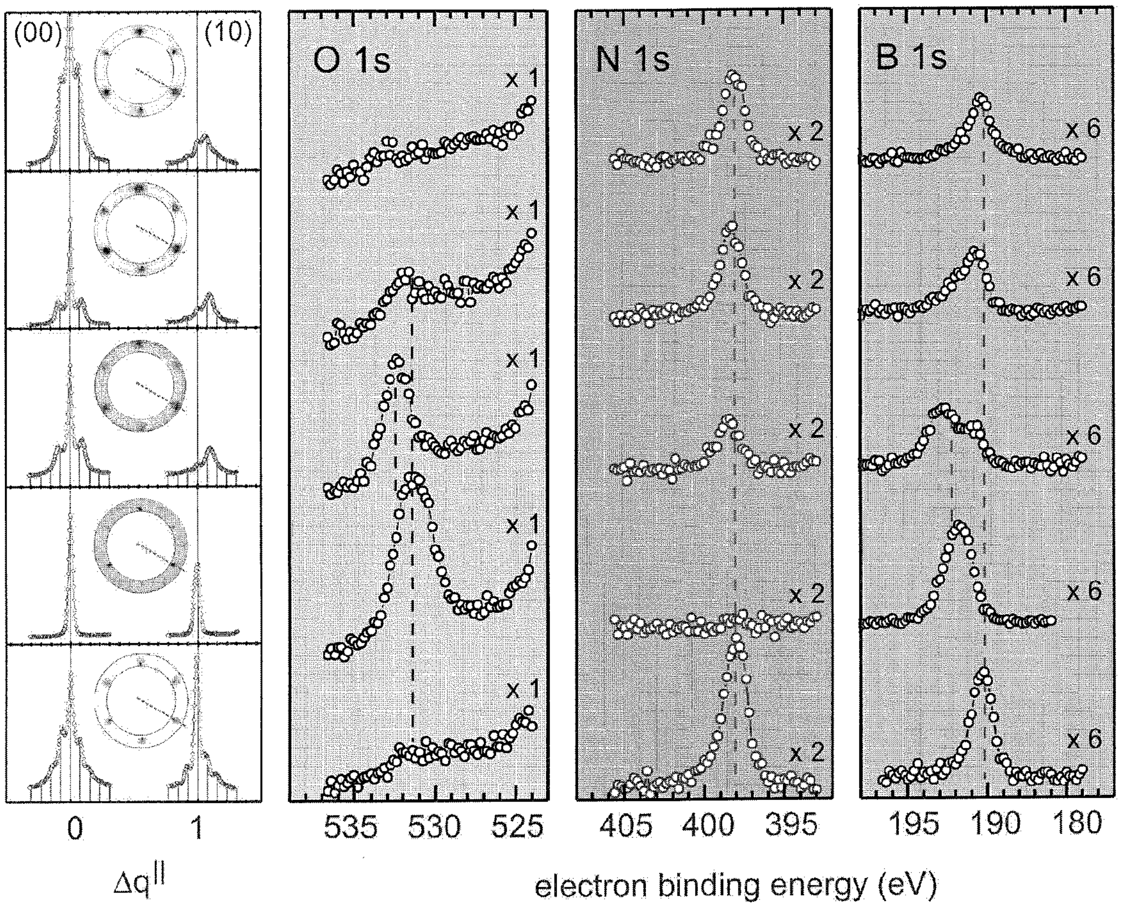
(00)
(10)
O 1s
N 1s
B 1s
x 1
x 2
x 6
0
1
Δq||
535
530
525
405
400
395
195
190
180
electron binding energy (eV)

**Fig. 18:**

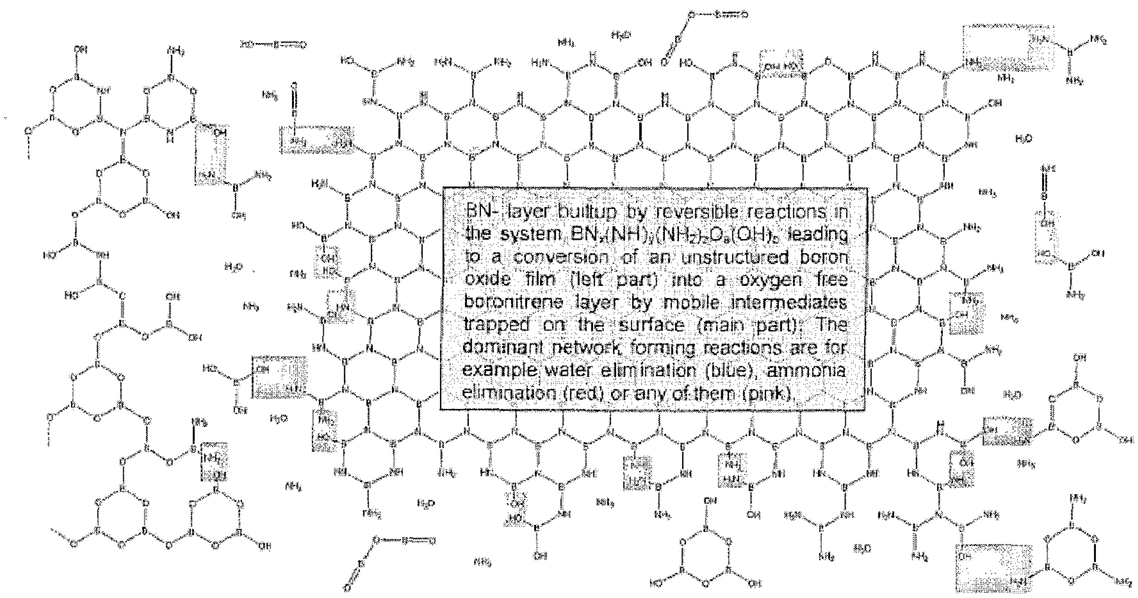
BN- layer builtup by reversible reactions in the system $BN_x(NH)_y(NH_2)_zO_a(OH)_b$ leading to a conversion of an unstructured boron oxide film (left part) into a oxygen free boronitrene layer by mobile intermediates trapped on the surface (main part). The dominant network forming reactions are for example water elimination (blue), ammonia elimination (red) or any of them (pink).

Fig. 19

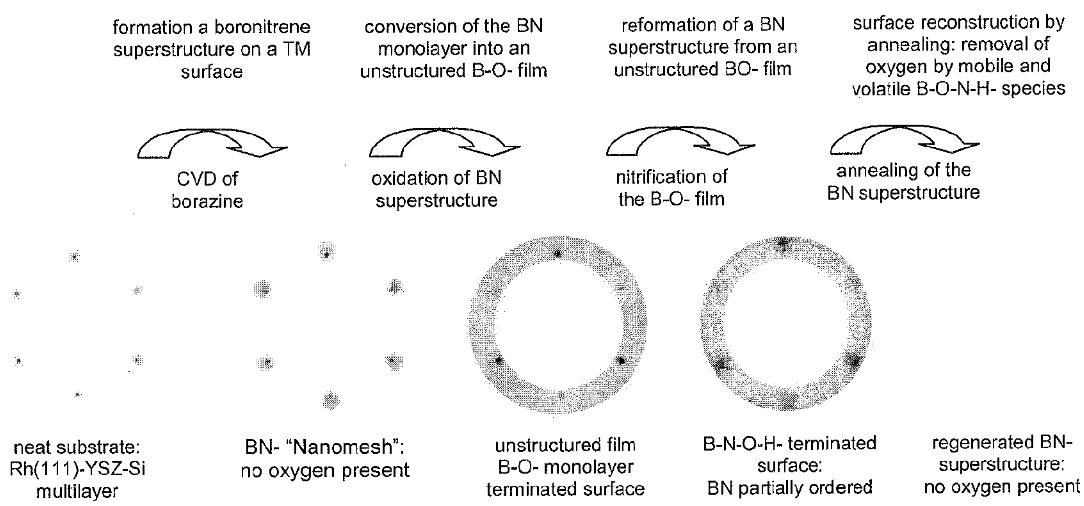
formation a boronitrene superstructure on a TM surface
conversion of the BN monolayer into an unstructured B-O- film
reformation of a BN superstructure from an unstructured BO- film
surface reconstruction by annealing: removal of oxygen by mobile and volatile B-O-N-H- species
CVD of borazine
oxidation of BN superstructure
nitrification of the B-O- film
annealing of the BN superstructure
neat substrate: Rh(111)-YSZ-Si multilayer
BN- "Nanomesh": no oxygen present
unstructured film B-O- monolayer terminated surface
B-N-O-H- terminated surface: BN partially ordered
regenerated BN-superstructure: no oxygen present

Fig. 20

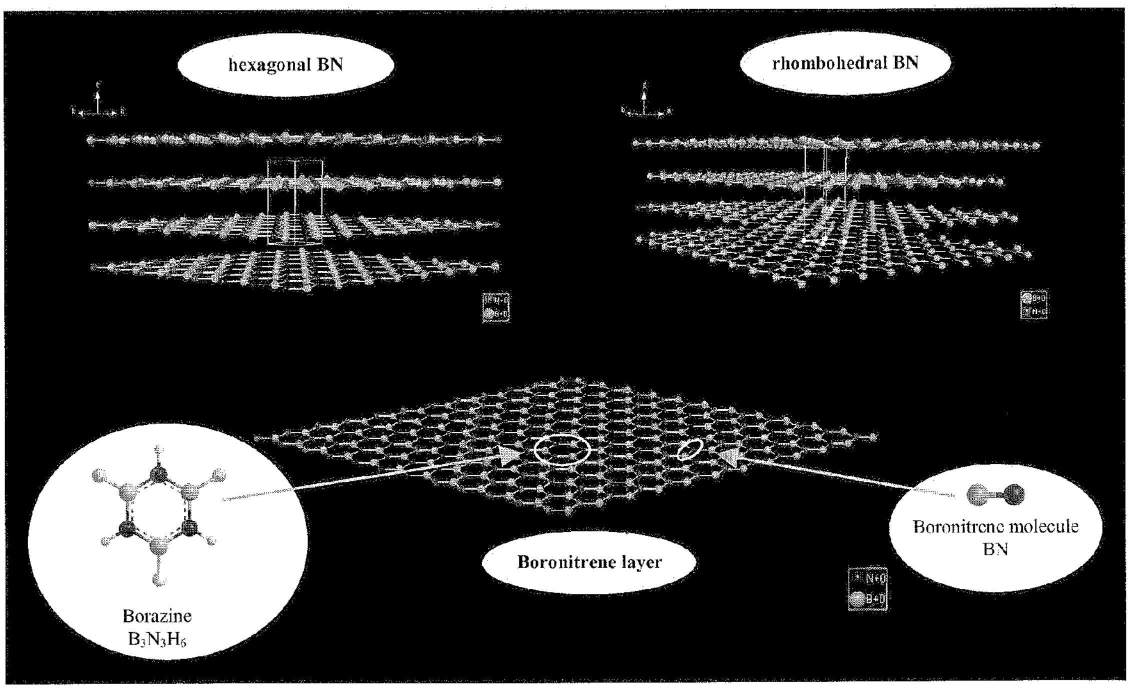
hexagonal BN
rhombohedral BN
Boronitrene layer
Borazine
$B_3N_3H_6$
Boronitrene molecule
BN

Europäisches Patentamt
European Patent Office
Office européen des brevets

# EUROPEAN SEARCH REPORT

Application Number
EP 09 16 9114

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 319 533 A (TRIKON EQUIP LTD [GB]) 27 May 1998 (1998-05-27)<br>* page 10, line 3 - line 8; figure 1 *<br>* page 1, line 4 *<br>* page 12, line 3 *<br>* page 13, line 25 *<br>* page 4, line 6 - line 8 *<br>----- | 1,6-7, 9-10 | INV.<br>C23C16/30<br>C23C16/34<br>C23C16/56<br>C30B33/00<br>C30B33/12<br>C30B25/02<br>C30B25/18 |
| X,D | MULLER F ET AL: "Epitaxial growth of boron nitride on a Rh(111) multilayer system: Formation and fine tuning of a BN-nanomesh"<br>SURFACE SCIENCE, NORTH-HOLLAND PUBLISHING CO, AMSTERDAM, NL,<br>vol. 603, no. 3,<br>1 February 2009 (2009-02-01), pages 425-432, XP025923833<br>ISSN: 0039-6028 [retrieved on 2008-11-05] | 9-12 | |
| A | * the whole document *<br>----- | 1 | |

TECHNICAL FIELDS SEARCHED (IPC)
C23C
C30B

~~The present search report has been drawn up for all claims~~

2

| Place of search | Date of completion of the search | Examiner |
|---|---|---|
| The Hague | 6 January 2010 | Schuhmacher, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

EPO FORM 1503 03.82 (P04C01)

Europäisches Patentamt
European Patent Office
Office européen des brevets

Application Number
EP 09 16 9114

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

6-7(completely); 1, 9-12(partially)

☐ The present supplementary European search report has been drawn up for those parts of the European patent application which relate to the invention first mentioned in the claims (Rule 164 (1) EPC).

Europäisches Patentamt
European Patent Office
Office européen des brevets

# LACK OF UNITY OF INVENTION SHEET B

Application Number
EP 09 16 9114

The Search Division considers that the present European patent application does not comply with the requirements of unity of invention and relates to several inventions or groups of inventions, namely:

1. claims: 6-7(completely); 1, 9-12(partially)

   Process for forming thin layers of metal nitrides as indicated in claim 1, wherein M is B

---

2. claims: 1, 9-12(partially)

   Process for forming thin layers of metal nitrides as indicated in claim 1, wherein M is Al

---

3. claims: 1, 9-12(partially)

   Process for forming thin layers of metal nitrides as indicated in claim 1, wherein M is Si or Ge

---

4. claims: 1, 9-12(partially)

   Process for forming thin layers of metal nitrides as indicated in claim 1, wherein M is Sn

---

5. claims: 1, 9-12(partially)

   Process for forming thin layers of metal nitrides as indicated in claim 1, wherein M is Zr or Hf

---

6. claims: 1, 9-12(partially)

   Process for forming thin layers of metal nitrides as indicated in claim 1, wherein M is a lanthanide or actinide

---

7. claims: 2-4

   Process for forming thin layers of metal nitrides as indicated in claim 1, wherein the substrate has a surface having a hexagonal or pseudohexagonal structure

---

8. claim: 5(completely); 11(partially)

   Process for forming thin layers of metal nitrides as indicated in claim 1, wherein the thin layer is a monolayer

---

9. claims: 8, 13-23, 25(completely); 9-12(partially)

Europäisches Patentamt
European Patent Office
Office européen des brevets

## LACK OF UNITY OF INVENTION SHEET B

Application Number

EP 09 16 9114

The Search Division considers that the present European patent application does not comply with the requirements of unity of invention and relates to several inventions or groups of inventions, namely:

Use of M(OR)x in a process of forming thin layers of metal nitrides as indicated in claim 8, 18, 19 and 25 ;
uses of these layers as indicated in claims 10-19, 22 and 23; and
articles obtainable by that use as indicated in claims 9, 20 and 21.

---

10. claim: 24(partially)

Article, comprising an epitaxial Rh(111) substrate and provided thereon, a hardened surface comprising implanted M atoms, wherein M is an element selected from the group consisting of B, AI, Si, Ge, Sn Ti, Zr, Hf, the lanthanides, the actinides and the transition metals.

---

11. claim: 24(partially)

Article, comprising an epitaxial Rh(111) substrate and provided thereon, a thin oxide layer,

---

12. claim: 26

Process for obtaining metal hydrides and aldehydes/ketones as indicated in claim 26.

---

## ANNEX TO THE EUROPEAN SEARCH REPORT ON EUROPEAN PATENT APPLICATION NO. EP 09 16 9114

This annex lists the patent family members relating to the patent documents cited in the above-mentioned European search report.
The members are as contained in the European Patent Office EDP file on
The European Patent Office is in no way liable for these particulars which are merely given for the purpose of information.

06-01-2010

| Patent document cited in search report | Publication date | Patent family member(s) | Publication date |
|---|---|---|---|
| GB 2319533 A | 27-05-1998 | CN 1208953 A | 24-02-1999 |
| | | DE 19751784 A1 | 28-05-1998 |
| | | JP 10199831 A | 31-07-1998 |
| | | US 6174823 B1 | 16-01-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **M. Engler et al.** *cfi/Ber. DKG,* 2007, vol. 84 (12), E49-E53
- **R. Laskowski et al.** *Phys. Rev. Lett.,* 2007, vol. 98, 106802
- **R. Laskowski et al.** *J. Phys. Condens. Matter,* 2008, vol. 20, 064207
- **M. Corso et al.** *Science,* 2004, vol. 303, 217
- **S: Berner et al.** *Angewandte Chemie,* 2007, vol. 46, 5115
- **H. Dil et al.** *Science,* 2008, vol. 319, 1826
- **S. Berner et al.** *Angew. Chemie,* 2007, vol. 46, 5115
- *Nature Nanotechnology,* 2007, vol. 2, 459
- **A. Goriachko et al.** *J. Phys. Chem. C,* 2008, vol. 112, 10432-10427
- **H. Sachdev et al.** *Diamond and Related Materials,* 1999, vol. 8, 319
- **B. Lux et al.** *Super Carbon,* 1998, 127
- **X. W: Zhang et al.** *Nature Materials,* 2003, vol. 2, 1539
- **J. Yu et al.** *Diamond Related Materials,* 2003, vol. 12, 1539
- **P.B. Mirkarimi et al.** *J. Mater. Res.,* 1994, vol. 9, 2925
- **R.C: de Vries et al.** *J. Cryst. Growth,* 1972, vol. 13-14, 88
- **O. Mishima et al.** *Science,* 1987, vol. 238, 181
- **O. Fukunaga et al.** *Diamond Relat. Mater.,* 2004, vol. 13, 1709
- **T. Taniguchi et al.** *Jpn. J. Appl. Phys.,* 2002, vol. 41, L109-L111
- **Y. Kubota et al.** *Science,* 2007, vol. 317, 932-934
- **H. Sachdev et al.** *Diamond and Related Materials,* 2000, vol. 9, 614-619
- **H. Sachdev.** *Diamond and Related Materials,* 2000, vol. 10, 1390-1397
- **Nagashima et al.** *Surf. Sci.,* 1996, vol. 357-358, 307
- **F. Müller et al.** *Surf. Sci.,* 2002, vol. 520, 158
- **F. Müller et al.** *Surf. Sci.,* 2008, vol. 602, 3467
- **F. Müller et al.** *Chem. Mater.,* 2005, vol. 17, 3464
- **A.B. Preobrajenski et al.** *Phys. Rev. B,* 2007, vol. 75, 245412
- **M. Morscher et al.** *Surf. Sci.,* 2006, vol. 600, 3280
- **W. Auwärter.** *Surf. Sci.,* 1999, vol. 429, 229
- **W. Auwärter et al.** *Chem. Mater.,* 2004, vol. 16, 343
- **W. Auwärter et al.** *Surf. Sci.,* 2003, vol. 545, L735
- **J. Osterwalder et al.** *e-J. Surf. Sci. Nanotech.,* 2003, vol. 1, 124
- **M. Muntwiler et al.** *Phys. Rev. B,* 2007, vol. 75, 075407
- **T. Greber et al.** *Proceedings ALC05, e-J. Surf. Sci. Nanotech.,* 2006, vol. 4, 410
- **M.T. Paffett et al.** *Surf. Sci.,* 1990, vol. 232, 286
- **M. Corso et al.** *Surf. Sci.,* 2005, vol. 577, L78
- **A. Goriachko et al.** *Langmuir (Letters),* 2007, vol. 23, 2928
- **M.P. Allan.** *Nanoscale Res. Lett.,* 2007, vol. 2, 94
- **O.R. Lourie et al.** *Chem. Mater.,* 2000, vol. 12, 1808
- **K.T. Moon et al.** *Journal of Ind. And. Eng. Chemistry,* 1997, vol. 3, 288
- **R. Laskowski et al.** *Phys. Rev. B,* 2008, vol. 78, 045409
- **S. Gsell et al.** *J- Crystal Growth,* vol. 311, 3731
- **F. Müller et al.** *Surf. Sci.,* 2009, vol. 603, 425
- **H.C. Hamaker et al.** *Phys. Rev. B,* 1983, vol. 27 (11), 6713
- **A. Geim ; K. Novoselov.** *Nature Materials,* 2007, vol. 6, 183
- **V.L. Solozhenko et al.** *Solid State Commun.,* 1994, vol. 90, 65
- **F. Müller.** *Surf. Sci.,* 2009, vol. 603, 425
- **W. Moddeman et al.** *Surface and Interface Analysis,* 1989, vol. 14, 224
- **H.C: Hamaker et al.** *Phys. Rev. B,* 1983, vol. 27 (11), 6713
- **F: Hollemann ; E: Wiberg.** Lehrbuch der Anorganischen Chemie. 1985, vol. 91, 1104-1108
- **J. Kiss et al.** *Appl. Surf. Sci.,* 1989, vol. 37, 95
- **D.N. Hendrickson et al.** *Inorg. Chem.,* 1969, vol. 9, 612
- **J.A. Schreifels et al.** *J. Catal.,* 1980, vol. 65, 195

- **M. Elango et al.** *J. Phys. Chem. A,* 2008, vol. 112, 8107
- **M.P. Seah et al.** *Surf. Interface Anal.,* 1979, vol. 1, 2
- **F: Müller et al.** *Surf. Sci.,* 2008, vol. 602, 3467-3476
- **M. Romand et al.** *Analysis,* 1976, vol. 4, 308
- **F. Müller et al.** *Surf. Sci.,* 2008, vol. 602, 3467-3476
- **M. Corso.** *Science,* 2004, vol. 303, 217